# EUROPEAN PATENT APPLICATION

(11) **EP 4 386 612 A1**
(43) Date of publication of application: **19.06.2024**
(21) Application number: 22874460.3
(22) Date of filing: 16.08.2022
(51) Int. Cl.: G06F 30/20, G06F 30/15, G07C 5/08, B60W 50/04

(54) **PARAMETER CALIBRATION METHOD AND APPARATUS**

(30) Priority: 29.09.2021 CN 202111148039
(71) Applicant: Huawei Technologies Co., Ltd., Shenzhen, Guangdong 518129 (CN)
(72) Inventor: GU, Qiang, Shenzhen, Guangdong 518129 (CN); ZHUANG, Yuzheng, Shenzhen, Guangdong 518129 (CN); LIU, Donghao, Shenzhen, Guangdong 518129 (CN); LUO, Jie, Shenzhen, Guangdong 518129 (CN); WANG, Bin, Shenzhen, Guangdong 518129 (CN)
(74) Representative: Isarpatent
(86) International application number: PCT/CN2022/112810
(87) International publication number: WO 2023/051065

(57) **Abstract**

This application provides a parameter calibration method and apparatus that may be applied to vehicles such as an intelligent vehicle, a new energy vehicle, a connected vehicle, and an intelligent driving vehicle. The method includes: obtaining evaluation results of parameter combinations of a plurality of devices, where the evaluation results of the parameter combinations of the plurality of devices are obtained by respectively performing calibration tests by the plurality of devices in a first time period based on the parameter combinations of the plurality of devices; and obtaining at least one adjusted parameter combination based on the evaluation results of the parameter combinations of the plurality of devices. Solutions in this application can improve parameter calibration efficiency.

## Description

This application claims priority to Chinese Patent Application No. 202111148039.4, filed with the China National Intellectual Property Administration on September 29, 2021 and entitled "PARAMETER CALIBRATION METHOD AND APPARATUS", which is incorporated herein by reference in its entirety.

### TECHNICAL FIELD

This application relates to the data processing field, and more specifically, to a parameter calibration method and apparatus.

### BACKGROUND

Parameter calibration refers to a process of searching for a group of parameters that are applicable under a plurality of conditions, such as different hardware conditions or different environmental conditions. Vehicle calibration is used as an example. The vehicle calibration refers to a process of optimizing parameters in control software to achieve satisfactory vehicle performance, meet requirements before delivery of a vehicle and meet relevant national standards after components such as controller hardware, the control software, and related sensors are determined.

Vehicle calibration results are important factors affecting related performance of the vehicle. Before the vehicle is launched, the calibration is usually performed by an experienced calibration engineer based on a prototype vehicle. To make the vehicle meet performance requirements under various working conditions, it is necessary to carry out calibration experiments under different working conditions to find suitable parameter combinations. Due to limitations of working conditions, environments, and the like, a calibration process takes a long time and calibration costs are high. A braking system in the vehicle is used as an example. It usually takes a long calibration process of "two summers and one winter" to complete parameter calibration in the braking system. This seriously affects calibration efficiency.

Therefore, how to improve parameter calibration efficiency is an urgent problem to be resolved.

### SUMMARY

This application provides a parameter calibration method and apparatus, to improve parameter calibration efficiency.

According to a first aspect, a parameter calibration method is provided, including: obtaining evaluation results of parameter combinations of a plurality of devices, where the evaluation results of the parameter combinations of the plurality of devices are obtained by respectively performing calibration tests by the plurality of devices in a first time period based on the parameter combinations of the plurality of devices, and the first time period is less than or equal to a first threshold; and obtaining at least one adjusted parameter combination based on the evaluation results of the parameter combinations of the plurality of devices.

According to the solution in this embodiment of this application, the plurality of devices perform the calibration tests in a same time period. In this way, data collection efficiency can be improved, and parameters of the devices can be adjusted in real time based on the evaluation results of the parameter combinations of the plurality of devices. This further improves calibration efficiency, reduces a calibration cycle, and reduce calibration costs.

In the solution of this embodiment of this application, the plurality of devices may simultaneously perform the calibration tests under different working conditions. This improves calibration efficiency and reduces time costs and economic costs.

In the solution of this embodiment of this application, the plurality of devices may simultaneously be under different working conditions, so that real-time summary and parameter optimization of data of the plurality of devices can be implemented. This helps simultaneously search for a parameter combination compatible with a plurality of working conditions under the plurality of working conditions, thereby improving parameter stability, and further improving calibration efficiency.

In the solution of this embodiment of this application, parameter calibration is performed based on evaluation results of test data of the plurality of devices. This reduces cognitive deviations caused by different calibration engineers, thereby improving calibration quality, and helping avoid a case in which the devices are recalled after delivery.

In the solution in this embodiment of this application, calibration may alternatively be completed by using an automatic optimization algorithm, to reduce a quantity of calibration engineers, reduce labor costs, and further reduce impact of subjective preferences of the calibration engineers on a calibration result.

That the plurality of devices perform the calibration tests in the first time period may also be understood as that the plurality of devices may perform the calibration tests in the same time period. For example, the plurality of devices may simultaneously perform the calibration tests.

A parameter in a parameter combination is a parameter that needs to be calibrated. The parameter combination includes at least one parameter.

A parameter calibration apparatus may belong to the plurality of devices, or may not belong to the plurality of devices.

The parameter combinations of the plurality of devices may be the same or may be different.

The evaluation results of the parameter combinations of the plurality of devices indicate quality of the parameter combinations of the plurality of devices. An evaluation result of a parameter combination may also be understood as a value of the parameter combination.

Specifically, performance of the device may be evaluated based on one or more evaluation indicators, to obtain the evaluation result of the parameter combination.

The at least one adjusted parameter combination may be the same or may be different.

With reference to the first aspect, in some implementations of the first aspect, the parameter combinations of the plurality of devices are the same, and working conditions of the plurality of devices are different; and the obtaining at least one adjusted parameter combination based on the evaluation results of the parameter combinations of the plurality of devices includes: processing the evaluation results of the parameter combinations of the plurality of devices to obtain a summary evaluation result; and obtaining the at least one adjusted parameter combination based on the summary evaluation result.

The summary evaluation result may be determined in a plurality of manners. For example, a weighted average value of the evaluation results of the parameter combinations of the plurality of devices is used as the summary evaluation result. For another example, a minimum value in the evaluation results of the parameter combinations of the plurality of devices is used as the summary evaluation result. For still another example, a maximum value in the evaluation results of the parameter combinations of the plurality of devices is used as the summary evaluation result. A manner of determining the summary evaluation result is not limited in this embodiment of this application.

This helps summarize evaluation results of a same parameter combination under different working conditions, to obtain a summary evaluation result of the parameter combination. The current parameter combinations are optimized based on the summary evaluation result, to obtain a better parameter combination, thereby improving calibration efficiency.

With reference to the first aspect, in some implementations of the first aspect, the method further includes: sending the at least one adjusted parameter combination to at least one device.

With reference to the first aspect, in some implementations of the first aspect, the at least one device is determined based on at least one of the following: the working conditions of the plurality of devices or the at least one adjusted parameter combination.

With reference to the first aspect, in some implementations of the first aspect, the evaluation results of the parameter combinations of the plurality of devices are obtained by evaluating the test data of the plurality of devices, and the test data of the plurality of devices is determined based on data collected in a process in which the plurality of devices respectively perform the calibration tests in the first time period based on the parameter combinations of the plurality of devices.

For example, the test data of the plurality of devices may be obtained by processing data collected by sensors in a process in which the plurality of devices respectively perform the calibration tests based on the parameter combinations of the plurality of devices.

For example, processing the data collected by the sensors may include performing processing such as filtering, frequency reduction, or noise reduction on the data collected by the sensors.

Alternatively, the test data of the plurality of devices may be data collected by sensors in a process in which the plurality of devices respectively perform the calibration tests based on the parameter combinations of the plurality of devices.

With reference to the first aspect, in some implementations of the first aspect, the evaluation results of the parameter combinations of the plurality of devices are obtained by evaluating the test data of the plurality of devices based on the working conditions of the plurality of devices.

In this embodiment of this application, evaluating the test data of the device based on the working condition of the device can improve accuracy of the evaluation result, thereby improving parameter calibration effect.

With reference to the first aspect, in some implementations of the first aspect, the evaluation results of the parameter combinations of the plurality of devices may be obtained by evaluating the test data of the plurality of devices based on configuration information of a plurality of vehicles.

In this embodiment of this application, evaluating the test data of the device based on the configuration information of the device can improve accuracy of an evaluation result, thereby improving parameter calibration effect.

With reference to the first aspect, in some implementations of the first aspect, the evaluation results of the parameter combinations of the plurality of devices are fed back by a user.

In this embodiment of this application, the evaluation results of the parameter combinations may be fed back by the user, so that user feelings can be fully considered. This helps improve user experience.

With reference to the first aspect, in some implementations of the first aspect, the method further includes: separately sending a to-be-executed action sequence of the at least one device to the at least one device, where the to-be-executed action sequence of the at least one device includes an action that needs to be performed by the at least one device in a process of performing a calibration test based on the adjusted parameter combination of the at least one device.

The at least one device may have a same to-be-executed action sequence or may have different to-be-executed action sequences.

For example, the to-be-executed action sequence of the at least one device may alternatively be determined by the at least one device.

Alternatively, the to-be-executed action sequence of the at least one device may be preset.

Alternatively, the to-be-executed action sequence of the at least one device may be determined by a user.

With reference to the first aspect, in some implementations of the first aspect, the to-be-executed action sequence of the at least one device is determined based on at least one of the following: an action that parameter calibration requires to cover, a working condition of the at least one device, or the evaluation results of the parameter combinations of the plurality of devices.

With reference to the first aspect, in some implementations of the first aspect, the plurality of devices include at least one of the following: a vehicle or a test bench.

With reference to the first aspect, in some implementations of the first aspect, the plurality of devices include the sensors.

According to a second aspect, a parameter calibration method is provided, including: obtaining an adjusted parameter combination, where the adjusted parameter combination is obtained based on evaluation results of parameter combinations of a plurality of devices, the plurality of devices include a first device, the evaluation results of the parameter combinations of the plurality of devices are obtained by respectively performing calibration tests by the plurality of devices in a first time period based on the parameter combinations of the plurality of devices, and the first time period is less than or equal to a first threshold; and controlling the first device to perform a calibration test based on the adjusted parameter combination.

According to the solution in this embodiment of this application, the plurality of devices perform the calibration tests in a same time period. In this way, data collection efficiency can be improved, and parameters of the devices can be adjusted in real time based on the evaluation results of the parameter combinations of the plurality of devices. This further improves calibration efficiency, reduces a calibration cycle, and reduce calibration costs.

In the solution of this embodiment of this application, the plurality of devices may simultaneously perform the calibration tests under different working conditions. This improves calibration efficiency and reduces time costs and economic costs.

In the solution of this embodiment of this application, the plurality of devices may simultaneously be under different working conditions, so that real-time summary and parameter optimization of data of the plurality of devices can be implemented. This helps simultaneously search for a parameter combination compatible with a plurality of working conditions under the plurality of working conditions, thereby improving parameter stability, and further improving calibration efficiency.

In the solution of this embodiment of this application, parameter calibration is performed based on evaluation results of test data of the plurality of devices. This reduces cognitive deviations caused by different calibration engineers, thereby improving calibration quality, and helping avoid a case in which the devices are recalled after delivery.

In the solution in this embodiment of this application, calibration may alternatively be completed by using an automatic optimization algorithm, to reduce a quantity of calibration engineers, reduce labor costs, and further reduce impact of subjective preferences of the calibration engineers on a calibration result.

With reference to the second aspect, in some implementations of the second aspect, the parameter combinations of the plurality of devices are the same, working conditions of the plurality of devices are different, the adjusted parameter combination is obtained based on a summary evaluation result, and the summary evaluation result is obtained by processing the evaluation results of the parameter combinations of the plurality of devices.

With reference to the second aspect, in some implementations of the second aspect, the first device is determined based on at least one of the following: the working conditions of the plurality of devices or the adjusted parameter combination.

With reference to the second aspect, in some implementations of the second aspect, the evaluation results of the parameter combinations of the plurality of devices are obtained by evaluating the test data of the plurality of devices, and the test data of the plurality of devices is determined based on data collected in a process in which the plurality of devices respectively perform the calibration tests in the first time period based on the parameter combinations of the plurality of devices.

With reference to the second aspect, in some implementations of the second aspect, the evaluation results of the parameter combinations of the plurality of devices are fed back by a user.

With reference to the second aspect, in some implementations of the second aspect, the method further includes: The first device obtains a to-be-executed action sequence of the first device, where the to-be-executed action sequence of the first device includes an action that needs to be performed by the first device in a process of performing the calibration test based on the adjusted parameter combination.

With reference to the second aspect, in some implementations of the second aspect, the to-be-executed action sequence of the first device is determined based on at least one of the following: an action that parameter calibration requires to cover, a working condition of the first device, or the evaluation results of the parameter combinations of the plurality of devices.

With reference to the second aspect, in some implementations of the second aspect, the first device is a vehicle or a test bench.

According to a third aspect, a parameter calibration apparatus is provided. The apparatus includes a module or a unit configured to perform the method in any one of the first aspect and the implementations of the first aspect.

According to a fourth aspect, a parameter calibration apparatus is provided. The apparatus includes a module or a unit configured to perform the method in any one of the second aspect and the implementations of the second aspect.

It should be understood that extensions to, limitations on, explanations for, and description of corresponding content in the first aspect are also applicable to same content in the second aspect, the third aspect, and the fourth aspect.

According to a fifth aspect, a parameter calibration apparatus is provided. The apparatus includes: a memory, configured to store a program; and a processor, configured to execute the program stored in the memory. When the program stored in the memory is executed, the processor is configured to perform the method in any implementation of the first aspect.

Optionally, the apparatus may further include a communication interface.

According to a sixth aspect, a parameter calibration apparatus is provided. The apparatus includes: a memory, configured to store a program; and a processor, configured to execute the program stored in the memory. When the program stored in the memory is executed, the processor is configured to perform the method in any implementation of the second aspect.

Optionally, the apparatus may further include a communication interface.

According to a seventh aspect, a computer-readable medium is provided. The computer-readable medium stores instructions that are executed by a device, and the instructions are used to perform the method in any implementation of the first aspect or the second aspect.

According to an eighth aspect, a computer program product including instructions is provided. When the computer program product runs on a computer, the computer is enabled to perform the method in any implementation of the first aspect or the second aspect.

According to a ninth aspect, a chip is provided. The chip includes a processor and a communication interface. The processor reads, through the communication interface, instructions stored in a memory, to perform the method in any implementation of the first aspect or the second aspect.

Optionally, the chip may further include the memory, the memory stores the instructions, and the processor is configured to execute the instructions stored in the memory. When the instructions are executed, the processor is configured to perform the method in any implementation of the first aspect or the second aspect.

According to a tenth aspect, an electronic device is provided. The electronic device includes the parameter calibration apparatus in any implementation of the third aspect or the fourth aspect.

### BRIEF DESCRIPTION OF DRAWINGS

FIG. 1 is a schematic diagram of an application scenario according to an embodiment of this application;
FIG. 2 is a schematic diagram of a calibration system according to an embodiment of this application;
FIG. 3 is a schematic diagram of another calibration system according to an embodiment of this application;
FIG. 4 is a schematic flowchart of a parameter calibration method according to an embodiment of this application;
FIG. 5A and FIG. 5B are a schematic flowchart of another parameter calibration method according to an embodiment of this application;
FIG. 6 is a schematic diagram of a parameter calibration apparatus according to an embodiment of this application; and
FIG. 7 is a schematic diagram of another parameter calibration apparatus according to an embodiment of this application.

### DESCRIPTION OF EMBODIMENTS

The following describes technical solutions of this application with reference to accompanying drawings.

The solutions in embodiments of this application can be applied to vehicle calibration, sensor calibration, and other fields in which parameter calibration is performed.

Parameter calibration refers to a process of determining a group of parameters that are applicable under a plurality of conditions, such as different hardware conditions or different environmental conditions. In other words, parameter calibration refers to a process of optimizing parameters under the plurality of conditions.

The following describes two application scenarios: vehicle calibration and sensor calibration.

### (1) Vehicle calibration

The vehicle calibration refers to a process of optimizing parameters in control software to achieve satisfactory vehicle performance, meet requirements before delivery of a vehicle and meet relevant national standards after components such as controller hardware, the control software, and related sensors are determined.

An electronic control unit (electronic control unit, ECU) in the vehicle, also referred to as a "vehicle computer", performs calculation by using data collected by various sensors to obtain control signals, so as to control each actuator in the vehicle to perform a corresponding action. For example, a control range of the ECU may include cruise control, lighting control, airbag control, suspension control, exhaust control, or brake control. ECUs may exchange data with each other through a bus. The parameter in the control software in embodiments of this application may be a parameter in the ECU.

In an existing parameter calibration process, calibration experiments are usually performed in a serial manner under different working conditions. Specifically, in a calibration experiment, after setting a parameter, a calibration engineer performs a calibration experiment, and adjusts the parameter based on data collected in the experiment. The foregoing process of performing the calibration experiment is repeated under a same working condition. After parameter calibration under this working condition is completed, a next working condition is transferred to for calibration. Calibration efficiency of this solution is low and a calibration cycle is long.

According to the solutions in embodiments of this application, parameter calibration efficiency of the vehicle can be improved, and calibration time costs can be reduced.

### (2) Sensor calibration

Some parameters of a sensor need to be calibrated in different environments before delivery, for example, a distortion calibration matrix of a camera, sensitivity of an inertial measurement unit (inertial measurement unit, IMU), and a deflection angle of a lidar mounted in a mobile phone.

A camera on a mobile phone is used as an example. Before delivery, parameter calibration needs to be performed in environments such as different lighting conditions, different temperatures, and different humidity, to obtain camera parameters applicable to different environments.

According to the solutions in embodiments of this application, parameter calibration efficiency of the sensor can be improved, and calibration time costs can be reduced.

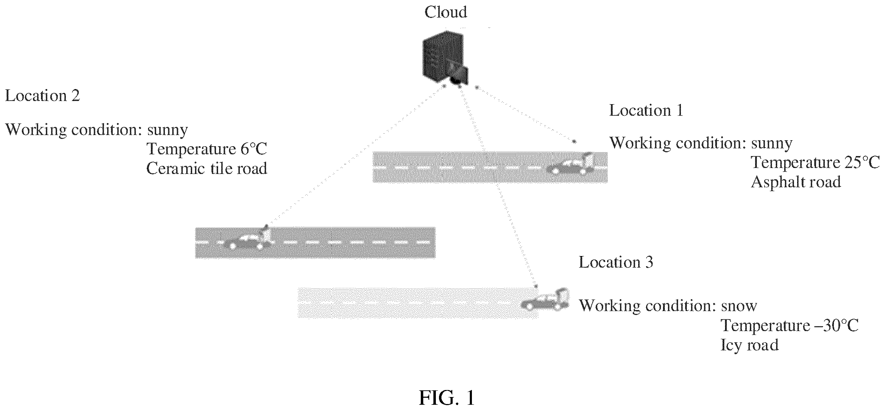

FIG. 1 is a schematic diagram of an application scenario according to an embodiment of this application.

As shown in FIG. 1, three vehicles of a same model perform parameter calibration in three test fields: a location 1, a location 2, and a location 3. As shown in FIG. 1, a working condition of a vehicle located at the location 1 includes: sunny, temperature 25°C, and asphalt road, a working condition of a vehicle located at the location 2 includes: sunny, temperature 6°C, and ceramic tile road, and a working condition of a vehicle at the location 3 includes: snow, temperature -30°C, and icy road.

The three vehicles may simultaneously perform parameter calibration by using the method in embodiments of this application. For example, the three vehicles may respectively perform calibration tests, and upload related data such as test data or evaluation results of parameter combinations, to a cloud. The cloud sends an adjusted parameter combination of each device to the vehicle, and repeats the foregoing process until the adjusted parameter combination can meet test requirements under the three working conditions. In this way, parameter calibration is completed. For specific descriptions, refer to a method 400 or a method 500 below.

Embodiments of this application provide a parameter calibration method, to implement parameter calibration based on evaluation results of parameter combinations of a plurality of devices, so as to improve parameter calibration efficiency and reduce calibration time costs.

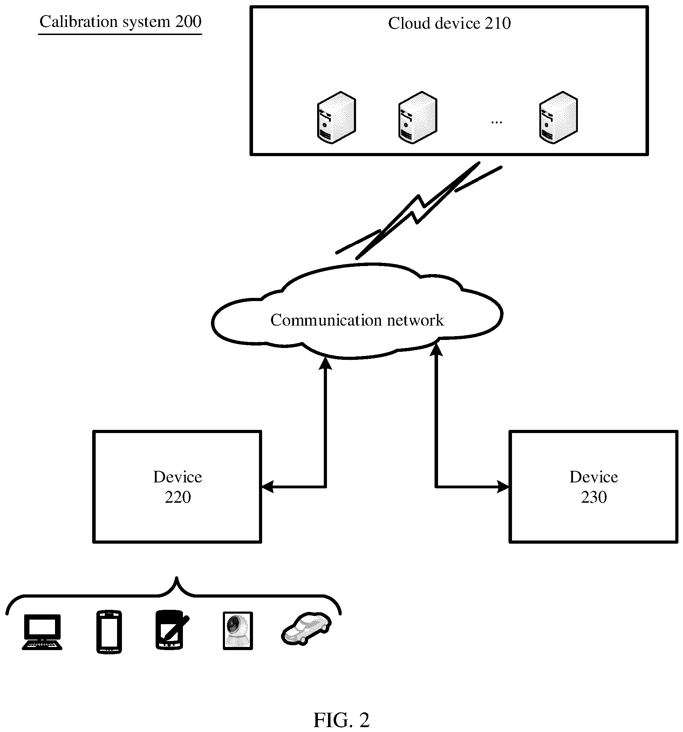

To better describe the solutions in embodiments of this application, the following describes a calibration system provided in embodiments of this application with reference to FIG. 2.

As shown in FIG. 2, a calibration system 200 may be deployed on a cloud side and a device side. For example, a cloud device 210 may be implemented by one or more servers. The device side includes a plurality of devices, and the plurality of devices (for example, a device 220 and a device 230) may interact with the cloud device 210. Each of the plurality of devices includes a module that needs to perform parameter calibration. For example, the plurality of devices may include a smartphone, a tablet computer, a smart camera, a vehicle, a media consumption device, or a wearable device. The plurality of devices may interact with the cloud device 210 by using a communication network of any communication mechanism/communication standard. The communication network may be the internet, the world wide web, an intranet, a virtual private network, a wide area network, a local area network, a private network using one or more companies' proprietary communication protocols, the Ethernet, Wi-Fi, an HTTP, and various combinations thereof. Such communication may be performed by any device that can transmit data to and from another computer, for example, a modem or a wireless interface.

It should be noted that all functions of the cloud device 210 may alternatively be implemented by the plurality of devices. For example, the device 220 performs a function of the cloud device 210, to provide a calibration service for the device 220 or provide a calibration service for the device 230. In this case, the calibration system 200 does not need to be deployed on the cloud side. In other words, the cloud device 210 is optional.

It should be noted that the plurality of devices (for example, the device 220 and the device 230) may be devices of a same type, or may be devices of different types. For example, the plurality of devices may include a plurality of vehicles. For another example, the plurality of devices may include a plurality of vehicles and a plurality of test benches.

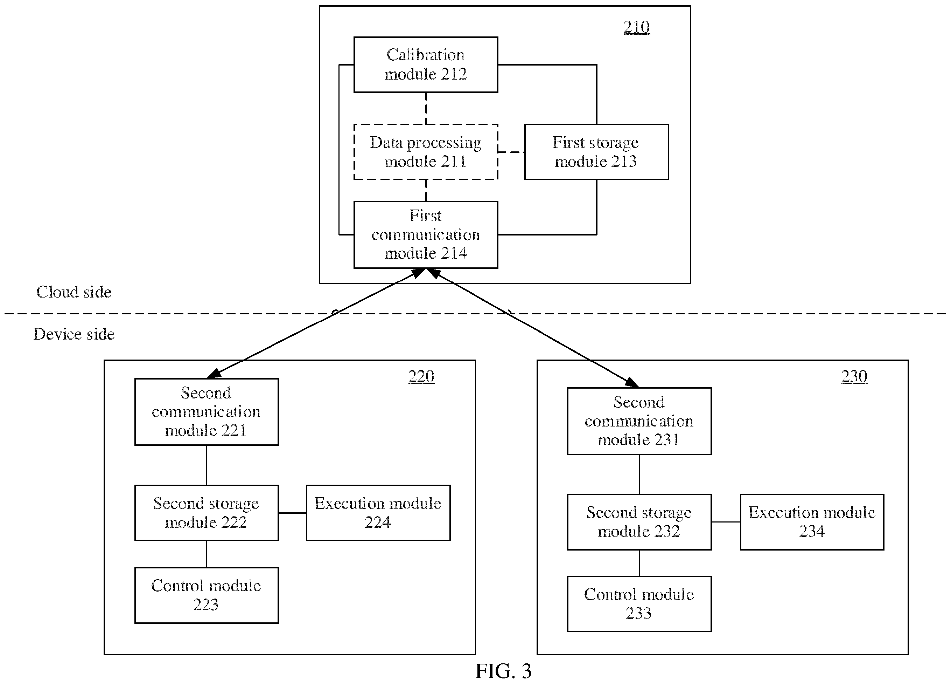

FIG. 3 is a schematic block diagram of a calibration system according to an embodiment of this application. FIG. 3 may be considered as a specific implementation of the calibration system 200 shown in FIG. 2.

As shown in FIG. 3, the calibration system 200 includes a data processing module 211, a calibration module 212, a first storage module 213, and a first communication module 214 that are deployed on the cloud device 210. The calibration system further includes second communication modules, second storage modules, control modules, and execution modules of the plurality of devices that are deployed on the device side. For example, the calibration system 200 further includes a second communication module 221, a second storage module 222, a control module 223, and an execution module 224 that are deployed in the device 220, and a second communication module 231, a second storage module 232, a control module 233, and an execution module 234 that are deployed in the device 230.

It should be understood that "first" and "second" in the "first communication module" and the "second communication module" in this embodiment of this application are merely used to distinguish between a communication module on the cloud side and a communication module on the device side, and have no other limiting function. Correspondingly, "first" and "second" in the "first storage module" and the "second storage module" are merely used to distinguish between a storage module on the cloud side and a storage module on the device side, and have no other limiting function.

The first communication module 214 is configured to implement a communication connection between the cloud side and the device side. The communication connection may be a wired connection, or may be a wireless connection.

Specifically, the first communication module 214 is configured to receive at least one of the following: data of the device 220 and the device 230, or evaluation results of parameter combinations of the device 220 and the device 230.

For example, data of the device includes data collected by the device in a calibration test based on a current parameter combination.

Current parameter combinations of devices may be the same or may be different. Action sequences executed based on calibration tests of the devices may be the same or may be different.

Optionally, the first communication module 214 may be further configured to receive working conditions of the device 220 and the device 230.

The data processing module 211 is configured to process data received by the first communication module 214.

For example, the data received by the first communication module 214 includes the data of the device 220 and the device 230. The data processing module 211 may be configured to process the data of the device 220 and the device 230, and extract valid data. The valid data is data processed by the data processing module 211, that is, "test data" in the following description.

It should be noted that the data processing module 211 is an optional module. For example, if the data of the device includes only valid data, that is, if the data does not need to be processed, the data processing module 211 does not need to be disposed. For another example, if the data received by the first communication module 214 is the evaluation results of the parameter combinations of the device 220 and the device 230, the data processing module 211 does not need to be disposed. For still another example, the calibration module 212 may perform a function of the data processing module 211 and process the data. Therefore, the data processing module 211 does not need to be additionally disposed.

The calibration module 212 is configured to obtain at least one parameter combination based on the evaluation results of the parameter combinations of the plurality of devices (for example, the device 220 and the device 230).

Optionally, the calibration module 212 may be further configured to evaluate test data of the plurality of devices to obtain the evaluation results.

Optionally, the calibration module 212 may be further configured to determine a to-be-executed action sequence of at least one device in the plurality of devices.

Optionally, the calibration module 212 may be further configured to determine the at least one device.

For specific descriptions of the calibration module 212, refer to step S420 and step S430 in the method 400. Details are not described herein.

The first storage module 213 may be configured to store at least one of the following: the test data of the device 220 and the device 230, the evaluation results of the parameter combinations of the device 220 and the device 230, and the working conditions or action sequence sets of the device 220 and the device 230.

It should be understood that in FIG. 3, only one first storage module is used as an example. In actual application, the first storage module may include a plurality of storage modules. For example, the first storage module may include a working condition module, and the working condition module is configured to store working conditions of the plurality of devices, for example, the working conditions of the device 220 and the device 230. For another example, the first storage module may include a calibration data module, and the calibration data module is configured to store the test data of the plurality of devices, for example, the test data of the device 220 and the device 230.

Optionally, the first communication module 214 may be further configured to separately send the adjusted parameter combination of the at least one device to the at least one device.

Optionally, the first communication module 214 may be further configured to separately send the to-be-executed action sequence of the at least one device to the at least one device.

The following uses the device 220 as an example to describe the modules included in the device. The modules in device 230 may perform the same functions as the modules in device 220.

The second communication module 221 may be configured to cooperate with the first communication module 214 on the cloud side, to implement a communication connection between the device 220 and the cloud device 210.

Specifically, the second communication module 221 may be configured to receive an adjusted parameter combination of the device 220. The second communication module 221 may be further configured to send data of the device 220 or an evaluation result of a parameter combination of the device 220 to the first communication module 214.

Optionally, the second communication module 221 may be further configured to send a working condition of the device 220 to the first communication module 214.

Optionally, the second communication module 221 may be further configured to receive a to-be-executed action sequence of the device 220.

The parameter combination that is of the device 220 and that is received by the device 220 may be written into the control module 223. The control module 223 is configured to control the execution module 224 to execute the to-be-executed action sequence. A parameter in the control module 223 is a parameter that needs to be calibrated. FIG. 3 is merely an example, and the calibration system may not include the control module 223.

For example, the device 220 may be a vehicle. In this case, the control module 223 may be a vehicle-mounted ECU.

The execution module 224 is configured to execute the to-be-executed action sequence. A specific execution process may be performed in a form of self-driving, or may be performed by a driver.

FIG. 3 is merely an example, and the calibration system may not include the execution module 224.

The second storage module 222 is configured to store at least one of the following: the working condition of the device 220, the parameter combination of the device 220, and the to-be-executed action sequence of the device 220.

It should be understood that only an example in which each device in FIG. 3 includes one second storage module is used. In actual application, each device may include a plurality of storage modules. For example, the second storage module may include a working condition module, a parameter module, and an action module. The working condition module is configured to send the working condition of the device 220 to a cloud by using the second communication module 221. The parameter module is configured to store the parameter combination of the device 220, and write the parameter into the control module 223. The action module is configured to: store the to-be-executed action sequence of the device 220, and send the to-be-executed action sequence to the execution module 224.

It should be understood that an example in which a terminal device includes two vehicles is used in FIG. 3 to describe the calibration system, and this constitutes no limitation on the solutions in embodiments of this application. For example, the terminal device may alternatively include more vehicles. For another example, the terminal device in FIG. 3 may alternatively include another type of device.

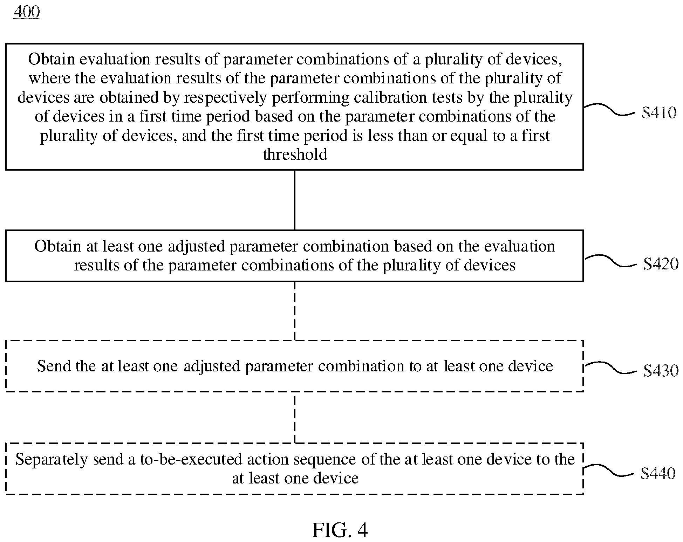

FIG. 4 is a schematic flowchart of a parameter calibration method according to an embodiment of this application. A method 400 shown in FIG. 4 may be performed by a parameter calibration apparatus. The parameter calibration apparatus may be a cloud service device or a terminal device, for example, a vehicle, a mobile phone, or a test bench, or may be a system including a cloud service device and a terminal device. Alternatively, the parameter calibration apparatus may be deployed on a cloud service device or a terminal device, or may be deployed on a system including a cloud service device and a terminal device. The cloud service device may also be referred to as a cloud.

For example, the method 400 may be performed by the calibration system shown in FIG. 3.

The method 400 shown in FIG. 4 includes step S410 to step S440.

S410: Obtain evaluation results of parameter combinations of a plurality of devices, where the evaluation results of the parameter combinations of the plurality of devices are obtained by respectively performing calibration tests by the plurality of devices in a first time period based on the parameter combinations of the plurality of devices, and the first time period is less than or equal to a first threshold.

For example, the first threshold may be 24 hours.

The first time period may be any time period, provided that a time interval of the time period is less than or equal to the first threshold. That the plurality of devices perform the calibration tests in the first time period may also be understood as that the plurality of devices may perform the calibration tests in a same time period. For example, the plurality of devices may simultaneously perform the calibration tests.

The plurality of devices are devices that need to perform parameter calibration. A parameter in a parameter combination is a parameter that needs to be calibrated. The parameter combination includes at least one parameter.

Specifically, in vehicle calibration, parameters in a parameter combination are a part or all of control parameters in an ECU.

For example, in transmitter calibration, a parameter in a parameter combination includes a control parameter related to a working state of a transmitter in an ECU. For example, the parameter combination may include an ignition advance angle.

In a process in which the plurality of devices respectively perform the calibration tests based on the parameter combinations of the plurality of devices, the plurality of devices respectively execute action sequences of the plurality of devices based on the parameter combinations of the plurality of devices.

The apparatus for performing step S410 may be deployed in the plurality of devices, or may be deployed in a device other than the plurality of devices, for example, may be deployed in the cloud.

Optionally, the plurality of devices may be a plurality of vehicles.

For example, the plurality of devices are m devices, and the m devices may be m vehicles, where m is an integer greater than 1.

In this case, the method 400 may be applied to a vehicle calibration scenario.

For example, the method 400 may be used to implement parameter calibration in scenarios such as an anti-lock braking system (anti-lock brake system, ABS) scenario, a vehicle steering system scenario, or a vehicle body electronic stability control (electronic stability controller, ESC) system scenario in vehicle calibration.

Optionally, the plurality of devices may include a plurality of test benches.

For example, the plurality of devices are m devices, and the m devices may be m test benches, where m is an integer greater than 1.

Optionally, the plurality of devices may include a vehicle and a test bench.

For example, the plurality of devices are m devices, and the m devices may include n vehicles and m-n test benches, where m is an integer greater than 1, and n is a positive integer less than m.

When the plurality of devices include a test bench, the method 400 may be applied to scenarios such as engine calibration or motor calibration in an electric vehicle.

Optionally, the plurality of devices may include a plurality of sensors. In this case, the method 400 may be applied to a sensor calibration scenario.

A camera on a mobile phone is used as an example. Before delivery, parameter calibration needs to be performed in different environments, for example, under different lighting conditions, different temperatures, or different humidity. The method 400 may be used to implement parameter calibration of the camera on the mobile phone.

The parameter combinations of the plurality of devices may be the same or may be different.

In this embodiment of this application, that the parameter combinations are different means that at least one parameter has different values in the parameter combinations, but does not mean that parameter items in the parameter combinations are different.

To improve parameter calibration efficiency, parameter items in the parameter combinations of the plurality of devices may be the same. For example, when the plurality of devices simultaneously perform parameter calibration in the ABS scenario, each of the parameter combinations of the plurality of devices includes a parameter item related to an ABS function. This can improve parameter calibration efficiency in the ABS scenario.

For example, a parameter value in a parameter combination of each device may be randomly determined in a parameter space. The parameter space may also be understood as a value range of a parameter. Alternatively, a parameter value in a parameter combination of each device may be determined based on a parameter value of a similar vehicle model. Alternatively, a parameter value in a parameter combination of each device may be manually set. Alternatively, an initial parameter combination of each device may be determined based on a working condition of the device. The parameter combinations of the plurality of devices may be determined in a same manner, or may be determined in different manners. A manner of determining the parameter value in the parameter combination of each device is not limited in this embodiment of this application.

The action sequences of the plurality of devices may be the same or may be different.

That the action sequences executed in the process in which the plurality of devices perform the calibration tests are different may also be understood as that the calibration tests are different.

The following uses the vehicle calibration scenario as an example to describe the action sequence.

For example, when parameter calibration is performed in the ABS scenario, a vehicle performs the following action sequence in a process of performing a calibration test: travelling to a start location, accelerating to a target speed, travelling at a constant speed, stepping on the brake pedal to the bottom until the vehicle stops, and travelling out of a test area.

Two action sequences including different target speeds may be considered as different action sequences. In other words, if two devices are accelerated to different target speeds in a process of performing calibration tests, it may be considered that different action sequences are executed.

For example, the action sequences of the plurality of devices may be randomly determined in an action sequence set. Alternatively, the action sequences of the plurality of devices may be determined based on at least one of the following: an action that parameter calibration requires to cover, a working condition of at least one device, or the evaluation results of the parameter combinations of the plurality of devices. Alternatively, the action sequences of the plurality of devices may be manually set. The action sequences of the plurality of devices may be determined in a same manner, or may be determined in different manners. This is not limited in this embodiment of this application.

Optionally, the plurality of devices meet at least one of the following: working conditions of the plurality of devices are different, the action sequences executed by the plurality of devices in the process of performing the calibration tests are different, or the parameter combinations of the plurality of devices are different.

If any two of the plurality of devices are under different working conditions, it may be considered that the plurality of devices are under different working conditions.

For example, when the method 400 is applied to the vehicle calibration scenario, a working condition may include at least one of the following: a road condition, a temperature, humidity, weather, or the like.

If any two of the plurality of devices have different parameter combinations, it may be considered that the parameter combinations of the plurality of devices are different.

If any two of the plurality of devices execute different action sequences in a process of performing calibration tests, it may be considered that the action sequences executed by the plurality of devices are different.

Whether the working conditions, the parameter combinations, and the action sequences of the plurality of devices are the same may be combined as required.

For example, devices under different working conditions execute a same action sequence based on a same parameter combination.

For example, when a value range of a parameter in a parameter combination is (0, 1), a plurality of devices under different working conditions execute a same action sequence when the parameter is 0.1.

For example, a plurality of devices under a same working condition execute a same action sequence based on different parameter combinations.

For example, when a value range of a parameter in a parameter combination is (0, 1), the plurality of devices under the same working condition are controlled to separately execute the same action sequence when the parameter has different values in the range (0, 1).

For example, devices under different working conditions execute different action sequences based on different parameter combinations.

In this embodiment of this application, the plurality of devices are controlled to perform the calibration tests under different working conditions, or the plurality of devices are controlled to perform the calibration tests based on different parameter combinations, or the plurality of devices are controlled to execute different action sequences, to improve efficiency of the calibration tests and obtain evaluation results of parameter combinations in various cases more quickly, or to collect evaluation results of parameter combinations in more cases, so as to complete parameter calibration as soon as possible. This helps improve parameter calibration efficiency.

Optionally, the parameter combinations of the plurality of devices are the same, and the working conditions of the plurality of devices are different.

This is beneficial to summarize evaluation results of a same parameter combination under different working conditions.

The evaluation results of the parameter combinations of the plurality of devices indicate quality of the parameter combinations of the plurality of devices. An evaluation result of a parameter combination may also be understood as a value of the parameter combination.

Evaluation of a parameter combination may also be understood as evaluation of performance of a device in a process of performing a calibration test based on the parameter combination.

Specifically, the performance of the device may be evaluated based on one or more evaluation indicators, to obtain an evaluation result of the parameter combination.

For example, the performance of the device may be scored based on each evaluation indicator, to obtain a score corresponding to each indicator, and the score corresponding to each indicator may be used as the evaluation result of the parameter combination. Alternatively, a score corresponding to each indicator is processed, and a comprehensive score obtained through processing is used as the evaluation result of the parameter combination.

Optionally, the evaluation results of the parameter combinations of the plurality of devices may be obtained by evaluating test data of the plurality of devices. The test data of the plurality of devices is determined based on data collected in the process in which the plurality of devices respectively perform the calibration tests based on the parameter combinations of the plurality of devices.

For example, the test data of the plurality of devices may be obtained by processing data collected by sensors in a process in which the plurality of devices respectively perform the calibration tests based on the parameter combinations of the plurality of devices.

For example, processing the data collected by the sensors may include performing processing such as filtering, frequency reduction, or noise reduction on the data collected by the sensors.

The following uses data filtering as an example for description.

The data collected by the sensors may include valid data and invalid data. In other words, the sensors collect both the valid data and the invalid data in the process of performing the calibration tests. The valid data is data related to parameter calibration, or data that can be used to evaluate the parameter combinations. The invalid data is data irrelevant to parameter calibration, or data that cannot be used to evaluate the parameter combinations.

In this case, the data collected by the sensors is filtered to extract the valid data, and the valid data is used as the test data.

For example, when parameter calibration is performed in the ABS scenario, the vehicle sequentially performs the following actions in the process of performing the calibration test: travelling to the start location, accelerating to the target speed, travelling at the constant speed for a time period, stepping on the brake pedal to the bottom until the vehicle stops, and travelling out of the test area. Data is collected in a process in which the vehicle performs all of the foregoing actions. Valid data is data collected in a period in which the brake pedal is stepped on to the bottom until the vehicle stops. In this case, the collected data may be processed to extract the valid data, and the valid data is used as test data.

In an implementation, a process of processing the data collected by the sensors may be performed by the apparatus for performing step S410. In other words, the apparatus for performing step S410 may receive the data that is uploaded by the plurality of devices and that is collected by the sensors of the plurality of devices, and process the data collected by the sensors to obtain the test data.

In another implementation, a process of processing the data collected by the sensors may alternatively be separately performed by the plurality of devices, and the plurality of devices send the test data obtained through processing to the apparatus for performing step S410.

Alternatively, the test data of the plurality of devices may be the data collected by the sensors in the process in which the plurality of devices respectively perform the calibration tests based on the parameter combinations of the plurality of devices.

If the data collected by the sensors includes only the valid data, in other words, only the valid data is collected in the process of performing the calibration tests, the collected data may also be used as the test data.

For example, when parameter calibration is performed in the ABS scenario, the vehicle sequentially performs the following actions in the process of performing the calibration test: travelling to the start location, accelerating to the target speed, travelling at the constant speed for a time period, stepping on the brake pedal to the bottom until the vehicle stops, and travelling out of the test area. Data is collected in a period in which the vehicle brakes (the brake pedal is stepped on to the bottom) until the vehicle stops. In this case, the collected data is the valid data, and the valid data is used as the test data.

In the process of performing the calibration tests, only the valid data is collected. This can reduce an operation of processing the collected data, thereby improving data processing efficiency, in other words, improving parameter calibration efficiency.

As described above, the evaluation results of the parameter combinations of the plurality of devices may be obtained by evaluating the test data of the plurality of devices.

In this case, the evaluation results of the parameter combinations may also be understood as a value of the test data.

Specifically, the test data may be evaluated based on one or more evaluation indicators, to obtain the evaluation results of the parameter combinations.

For example, the test data may be processed by using a cost (cost) function or a value (value) function, and an obtained cost value or value value may be used as the evaluation result of the parameter combination.

The following uses parameter calibration in the ABS scenario as an example for description.

Evaluation indicators of an ABS include wheel lockup time and a vehicle yaw angle.

Test data is obtained by performing a calibration test based on a current parameter combination of the ABS, and the vehicle lockup time and the vehicle yaw angle can be determined from the test data. In a braking process, longer vehicle lockup time in the test data indicates a larger vehicle yaw angle and worse braking performance of a current braking system, in other words, a lower value of the test data or a worse current parameter combination.

For example, the vehicle lockup time and the vehicle yaw angle in the test data may be separately evaluated by using the cost function, to obtain scores corresponding to the two indicators. The scores corresponding to the two indicators may be used as evaluation results of the current parameter combinations. Alternatively, the vehicle lockup time and the vehicle yaw angle in the test data may be evaluated by using the cost function, to obtain a comprehensive score. The comprehensive score may be used as an evaluation result of the current parameter combination.

Further, the evaluation results of the parameter combinations of the plurality of devices are obtained by evaluating the test data of the plurality of devices based on the working conditions of the plurality of devices.

For a same evaluation indicator, evaluation results of parameter combinations corresponding to test data under different working conditions may be different even if the test data under the different working conditions is the same.

The following uses parameter calibration in the ABS scenario as an example for description.

In the ABS scenario, the test data of the vehicle includes a braking distance. The braking distance is a braking distance obtained when the pedal is put to the metal. Braking distances under a same initial speed when emergency braking is used are evaluated based on road adhesion coefficients. Specifically, when the braking distances are the same, an evaluation result of a parameter combination under a working condition of a smaller road adhesion coefficient is better.

As described above, when parameter calibration is performed in the ABS scenario, the vehicle performs the following action sequence in the process of performing the calibration test: travelling to the starting location, accelerating to the target speed, travelling at the constant speed, stepping on the brake pedal to the bottom until the vehicle stops, and travelling out of the test area.

That the brake pedal is stepped on to the bottom until the vehicle stops means that emergency braking is used. An initial speed obtained when emergency braking is used is the target speed in the foregoing action sequence.

For example, the vehicle performs a same calibration test, in other words, performs a same action sequence, based on different parameter combinations under two different working conditions, namely, on a gravel road and on an asphalt road. Specifically, after the vehicle under the working condition of the gravel road executes the foregoing action sequence based on a parameter combination 1, a braking distance collected by a sensor is a. After the vehicle under the working condition of the asphalt road executes the foregoing action sequence based on a parameter combination 2, a braking distance collected by the sensor is b. A road adhesion coefficient of the gravel road is less than a road adhesion coefficient of the asphalt road. An evaluation score of the parameter combination 1 of the vehicle on the gravel road is higher than an evaluation score of the parameter combination 2 of the vehicle on the asphalt road when a and b are equal. It should be noted that same test data obtained herein under different working conditions is caused by different parameter combinations. In other words, when a same calibration experiment is performed based on the different parameter combinations under the different working conditions, evaluation scores of the different parameter combinations may be different even if the test data is the same.

In this embodiment of this application, evaluating the test data of the device based on the working condition of the device can improve accuracy of the evaluation result, thereby improving parameter calibration effect.

Further, the evaluation results of the parameter combinations of the plurality of devices may be obtained by evaluating the test data of the plurality of devices based on configuration information of the plurality of vehicles.

For a same evaluation indicator, evaluation results of parameter combinations corresponding to test data under different configurations may be different even if test data obtained under different configurations is the same.

The following uses parameter calibration in the ABS scenario as an example for description.

In the ABS scenario, the test data of the vehicle includes the braking distance. Configuration information of the vehicle may include a load weight of the vehicle. The braking distances under the same initial speed when emergency braking is used are evaluated based on a quantity of load weights of the vehicle. Specifically, when the braking distances are the same, an evaluation result of a parameter combination is better when the load weight of the vehicle is large.

For example, a collected braking distance is c in the process of performing the calibration test based on a parameter combination 3 when the load weight of the vehicle is 70 kg, and a collected braking distance is d in the process of performing the calibration test based on a parameter combination 4 when the load weight of the vehicle is 150 kg. An evaluation score of the parameter combination 3 is lower than an evaluation score of the parameter combination 4 when c and d are equal. Specifically, the braking distance may be multiplied by a coefficient corresponding to the braking distance, and then evaluation is performed. The coefficient corresponding to the braking distance may be manually set. The coefficient corresponding to the braking distance is negatively correlated with the load weight of the vehicle. For example, the load weight of the vehicle is 70 kg, and the coefficient corresponding to the braking distance is 1. The collected braking distance is c in the process of performing the calibration test based on the parameter combination 3, c is multiplied by 1, and then the evaluation score of the parameter combination 3 is obtained based on the processed braking distance. The load weight of the vehicle is 150 kg, and the coefficient corresponding to the braking distance is 0.95. The collected braking distance is d in the process of performing the calibration test based on the parameter combination 4, d is multiplied by 0.95, and then an evaluation result of the parameter combination 4 is obtained based on the processed braking distance.

In this embodiment of this application, evaluating the test data of the device based on configuration information of the device can improve accuracy of the evaluation result, thereby improving parameter calibration effect.

It should be understood that the foregoing parameter combination evaluation manner is merely an example, and the test data of the device may be evaluated in another manner. This is not limited in this embodiment of this application.

Optionally, the evaluation results of the parameter combinations of the plurality of devices may be fed back by a user.

In some application scenarios, when parameter calibration is performed, a subjective feeling feedback of the user is required. In other words, the user needs to evaluate use experience in a process of performing a calibration test to obtain an evaluation result of a parameter combination.

For example, the method 400 may be applied to the vehicle calibration scenario. In a process in which the vehicle performs a calibration test based on a current parameter combination, the user may score driving experience, and a score of the user may be used as an evaluation result of the current parameter combination.

For example, when parameter calibration of a vehicle steering system is performed, an evaluation indicator includes steering wheel assist effect. In a process of performing a calibration test, the steering wheel assist effect may be scored by a user.

For example, an evaluation result fed back by the user may be written into a device through a human-computer interaction interface.

This can fully consider user feeling, and helps improve user experience.

Optionally, first parts of the evaluation results of the parameter combinations of the plurality of devices are fed back by the user, and second parts of the evaluation results of the parameter combinations of the plurality of devices are obtained by evaluating the test data of the plurality of devices.

As described above, the performance of the device may be evaluated based on a plurality of evaluation indicators, to obtain the evaluation result of the parameter combination.

For example, the evaluation result may be represented in a form of a score corresponding to an evaluation indicator. In other words, an evaluation result of one parameter combination may include a plurality of scores. Some scores (examples of the second parts of the evaluation results) in the plurality of scores may be obtained by evaluating the test data of the plurality of devices, and other scores (examples of the first parts of the evaluation results) may be fed back by the user.

It should be understood that the foregoing parameter combination evaluation manner is merely an example, and the parameter combination may alternatively be evaluated in another manner. This is not limited in this embodiment of this application. For example, results fed back by the user and results obtained by evaluating the test data of the plurality of devices may alternatively be processed, to obtain the evaluation results of the parameter combinations.

In an implementation, the apparatus for performing step S410 may be deployed on the device other than the plurality of devices, for example, the cloud shown in FIG. 2.

Step S410 may be implemented in a plurality of manners. The following uses an example in which step S410 is performed on the cloud to describe a specific implementation of step S410.

For example, the cloud may receive the evaluation results of the parameter combinations of the plurality of devices.

For example, the cloud may receive the evaluation results that are of the parameter combinations of the plurality of devices and that are fed back by the user.

The plurality of devices may separately send the evaluation results of the parameter combinations of the plurality of devices to the cloud. The plurality of devices include a first device, to be specific, the first device may send an evaluation result of a parameter combination of the first device to the cloud.

Alternatively, the cloud may receive the test data of the plurality of devices, and evaluate the test data of the plurality of devices to obtain the evaluation results of the parameter combinations of the plurality of devices.

The plurality of devices may separately send the test data of the plurality of devices to the cloud. The plurality of devices include the first device, to be specific, the first device may send test data of the first device to the cloud.

Alternatively, the cloud may receive evaluation results of parameter combinations of some devices in the plurality of devices and test data of other devices, and evaluate the test data of the other devices to obtain evaluation results of parameter combinations of the other devices.

Some devices in the plurality of devices send the evaluation results of the respective parameter combinations to the cloud, and the other devices send the respective test data to the cloud.

For example, the plurality of devices include the first device and a second device. The second device sends an evaluation result of a parameter combination of the second device to the cloud, and the first device sends the test data of the first device to the cloud. Alternatively, the first device sends the evaluation result of the parameter combination of the first device to the cloud, and the second device sends test data of the second device to the cloud.

Alternatively, the cloud may receive the first parts of the evaluation results of the parameter combinations of the plurality of devices and the test data of the plurality of devices, and evaluate the test data of the plurality of devices to obtain the second parts of the evaluation results of the parameter combinations of the plurality of devices.

The plurality of devices may separately send the first parts of the evaluation results of the parameter combinations of the plurality of devices and the test data of the plurality of devices to the cloud.

For example, the plurality of devices include the first device. The first device may send a first part of the evaluation result of the parameter combination of the first device and the test data of the first device to the cloud.

The cloud may receive various types of data in a wired or wireless manner by using a communication module on the cloud. This is not limited in this embodiment of this application.

In another implementation, the apparatus for performing step S410 may be deployed in any one of the plurality of devices.

The apparatus for performing step S410 may obtain the evaluation results of the local parameter combinations in a plurality of manners.

For example, the apparatus for performing step S410 may read the evaluation results of the local parameter combinations. For example, the apparatus for performing step S410 may read or receive the evaluation results of the local parameter combinations from a storage module. For ease of description, in this embodiment of this application, "receiving" or "reading" of local data is collectively referred to as "reading".

Alternatively, the apparatus for performing step S410 may read the local test data, and evaluate the local test data to obtain the evaluation results of the local parameter combinations.

Alternatively, the apparatus for performing step S410 may read the first parts of the evaluation results of the local parameter combinations and the local test data, and evaluate the local test data to obtain the second parts of the evaluation results of the local parameter combinations. The first parts may be fed back by the user.

For a specific manner in which the apparatus for performing step S410 obtains an evaluation result of a parameter combination of a device in the plurality of devices other than a local device, refer to the foregoing obtaining manner on the cloud. To avoid repetition, details are not described herein again.

It should be noted that the evaluation results of the parameter combinations of the plurality of devices may be obtained at a time, or may be obtained for a plurality of times.

Optionally, the method 400 includes step S411 (not shown in FIG. 4).

S411: Obtain the working conditions of the plurality of devices.

For example, the working conditions of the plurality of devices may be collected by the sensors in the plurality of devices, or may be manually set.

For a specific obtaining manner, refer to step S410. In step S410, "the evaluation results of the parameter combinations of the plurality of devices" is replaced with "the working conditions of the plurality of devices", and details are not described herein again.

Optionally, the method 400 further includes step S412 (not shown in FIG. 4).

S412: Obtain configuration information of the plurality of devices.

For example, in the ABS scenario, the configuration information includes at least one of the following: a tire characteristic parameter, the load weight of the vehicle, or a distribution status of the load weight of the vehicle.

For example, the tire characteristic parameter may include at least one of the following: a degree of wear, a section width, or a flatness ratio.

For example, when there is only a driver in the vehicle, the load weight of the vehicle and the distribution status of the load weight of the vehicle may be expressed as [weight 70 kg, distributed on the left front side of the vehicle]. Alternatively, when there is a driver and a codriver in the vehicle, the load weight of the vehicle and the distribution status of the load weight of the vehicle may be expressed as [weight 150 kg, distributed on the front side of the vehicle].

For a specific obtaining manner, refer to step S410. In step S410, "the evaluation results of the parameter combinations of the plurality of devices" is replaced with "the configuration information of the plurality of devices", and details are not described herein again.

S420: Obtain at least one adjusted parameter combination based on the evaluation results of the parameter combinations of the plurality of devices.

The at least one adjusted parameter combination may be the same or may be different.

Step S420 may be understood as optimizing current parameter combinations based on the evaluation results of the parameter combinations of the plurality of devices. A specific optimization manner is implemented by using an existing optimization algorithm.

For example, step S420 may be implemented by using a Bayesian optimization (Bayesian Optimization) algorithm.

Specifically, a Gaussian process is fitted according to a Bayesian principle and based on the evaluation results of the parameter combinations of the plurality of devices, and then a mean value and a variance of evaluation results of value points in the parameter distribution space are obtained. One value point is one parameter combination. A score of each value point is calculated and a value point with a highest score is used as an adjusted parameter combination. For example, the score of each value point may be calculated by using an upper confidence bound (upper confidence bound, UCB) algorithm. Specifically, the mean value and the variance of the evaluation results of the value points are brought into a UCB formula to calculate the score of each value point, and at least one value point with the highest score is used as the at least one adjusted parameter combination.

For example, step S420 may be implemented by using a genetic algorithm.

For example, the plurality of devices include the m devices, and an operation such as crossover or mutation is performed on parameter combinations corresponding to p best evaluation results in evaluation results of parameter combinations of the m devices to obtain the at least one adjusted parameter combination, where p is an integer less than m and greater than 1.

It should be understood that the adjusted parameter combination may alternatively be obtained in another optimization manner. A specific implementation of an optimization process is not limited in this embodiment of this application.

Optionally, the parameter combinations of the plurality of devices are the same, and the working conditions of the plurality of devices are different. In this case, step S420 may be implemented by using the following steps:

(1) Process the evaluation results of the parameter combinations of the plurality of devices to obtain a summary evaluation result.

The summary evaluation result may be determined in a plurality of manners. For example, a weighted average value of the evaluation results of the parameter combinations of the plurality of devices is used as the summary evaluation result. For another example, a minimum value in the evaluation results of the parameter combinations of the plurality of devices is used as the summary evaluation result. For still another example, a maximum value in the evaluation results of the parameter combinations of the plurality of devices is used as the summary evaluation result. A manner of determining the summary evaluation result is not limited in this embodiment of this application.

(2) Obtain the at least one adjusted parameter combination based on the summary evaluation result.

Step (2) may be understood as optimizing the current parameter combinations based on the summary evaluation result. For a specific optimization manner, refer to the foregoing descriptions. For example, when the Bayesian optimization algorithm is used, "the evaluation results of the parameter combinations of the plurality of devices" in the foregoing optimization method is replaced with "the summary evaluation result".

Because parameter combinations of all the devices are the same, evaluation results under various working conditions may be summarized to obtain a summary evaluation result of the parameter combinations. The current parameter combinations are optimized based on the summary evaluation result. This helps obtain a better parameter combination, thereby improving calibration efficiency.

According to the solution in this embodiment of this application, the plurality of devices perform the calibration tests in the same time period. In this way, data collection efficiency can be improved, and parameters of the devices can be adjusted in real time based on the evaluation results of the parameter combinations of the plurality of devices. This further improves calibration efficiency, reduces a calibration cycle, and reduce calibration costs. For example, different devices may execute different action sequences to quickly overwrite action sequences that need to be completed, thereby improving data collection efficiency. For another example, different devices may perform calibration tests based on different parameter combinations to quickly cover the parameter space and improve data collection efficiency. For still another example, different devices may be under different working conditions to quickly cover working conditions required for calibration and improve data collection efficiency.

In an existing vehicle calibration process, calibration needs to be completed in a serial manner under different working conditions, parameters, and the like, and a vehicle can be transported to another test field for parameter calibration only after calibration in one test field is completed. In the solution of this embodiment of this application, the plurality of devices may simultaneously perform the calibration tests under different working conditions, thereby improving calibration efficiency and reducing time costs and economic costs.

In an existing calibration solution, calibration is usually completed under one working condition and then performed under another working condition. After calibration is completed, the calibration needs to be performed under a previous working condition for verification and adjustment. In the solution of this embodiment of this application, the plurality of devices may simultaneously be under different working conditions, so that real-time summary and parameter optimization of data of the plurality of devices can be implemented. This helps simultaneously search for a parameter combination compatible with a plurality of working conditions under the plurality of working conditions, thereby improving parameter stability, and further improving calibration efficiency.

In addition, a subjective preference of a calibration engineer during calibration affects accuracy of a calibration result. In the solution of this embodiment of this application, parameter calibration is performed based on evaluation results of the test data of the plurality of devices. This reduces cognitive deviations caused by different calibration engineers, thereby improving calibration quality, and helping avoid a case in which the devices are recalled after delivery.

In addition, in the solution in this embodiment of this application, calibration may alternatively be completed by using an automatic optimization algorithm, to reduce a quantity of calibration engineers, reduce labor costs, and further reduce impact of subjective preferences of the calibration engineers on the calibration result.

The method 400 further includes step S430.

S430: Send the at least one adjusted parameter combination to the at least one device.

Optionally, the at least one device may be determined based on at least one of the following: the working conditions of the plurality of devices or the at least one adjusted parameter combination.

For example, the at least one adjusted parameter combination is obtained by adjusting one or more parameter values in the current parameter combinations, and an adjusted parameter item may be valid only for a working condition with a low adhesion coefficient, and is invalid for a working condition with a high adhesion coefficient. In this case, the at least one device may be a device under the working condition with the low adhesion coefficient.

For another example, the evaluation results of the parameter combinations of the plurality of devices may be obtained for a plurality of times. In this case, a device that obtains a parameter combination of one or more devices each time may be used as the at least one device. The at least one adjusted parameter combination may also be understood as an adjusted parameter combination of the at least one device. Step S420 may also be understood as adjusting a parameter combination of the at least one device in the plurality of devices based on the evaluation results of the parameter combinations of the plurality of devices, to obtain the adjusted parameter combination of the at least one device. It should be noted that the "adjusting a parameter combination of the at least one device in the plurality of devices" herein refers to adjusting the parameter combination that is of the at least one device and that is stored in the apparatus for performing step S410, but does not limit a parameter combination stored in the at least one device.

It should be understood that the foregoing is merely an example. Alternatively, the at least one device may be determined in another manner. This is not limited in this embodiment of this application. For example, the at least one device may be randomly determined.

As described above, the at least one adjusted parameter combination may be the same or may be different.

For example, the at least one adjusted parameter combination may be the same. In this case, parameter combinations received by the at least one device are the same.

For another example, the at least one adjusted parameter combination may one-to-one corresponds to the at least one device. In this case, parameter combinations received by the at least one device may be different.

The at least one device may continue to perform a calibration test based on the adjusted parameter combination. The method 400 may be repeated until calibration is complete.

The at least one device includes the first device. For ease of description, only the first device is used as an example for description herein. Another device in the at least one device may perform an action the same as that of the first device.

One adjusted parameter combination in the at least one adjusted parameter combination is sent to the first device. The first device obtains the adjusted parameter combination, and performs a calibration test based on the adjusted parameter combination.

For a same device, action sequences executed for each calibration test may be the same or may be different.

That the method 400 is applied to vehicle calibration is used as an example. The at least one device may separately write the adjusted parameter combination into an ECU in the at least one device, and then may perform the calibration test based on the adjusted parameter combination.

It should be understood that step S430 is optional. When the apparatus for performing step S410 is not deployed in the first device and is a device different from the first device, the method 400 may further include step S430. When the apparatus for performing step S410 is deployed in the first device, the apparatus for performing step S410 may directly update the locally stored parameter combination to the adjusted parameter combination without performing step S430.

Optionally, the method 400 further includes step S440.

S440: Separately send a to-be-executed action sequence of the at least one device to the at least one device. The to-be-executed action sequence of the at least one device includes an action that needs to be performed by the at least one device in a process of performing the calibration test based on the adjusted parameter combination of the at least one device.

In other words, content of a to-be-executed calibration test is sent to each device.

The at least one device may have a same to-be-executed action sequence or may have different to-be-executed action sequences.

The at least one device includes the first device. For ease of description, only the first device is used as an example for description herein. The another device in the at least one device may perform the action the same as that of the first device.

The first device obtains a to-be-executed action sequence of the first device. The to-be-executed action sequence of the first device includes an action that needs to be executed by the first device in a process of performing the calibration test based on an adjusted parameter combination of the first device.

It should be understood that step S440 is optional. The to-be-executed action sequence of the at least one device may alternatively be determined in the following manner.

For example, the to-be-executed action sequence of the at least one device may alternatively be determined by the at least one device.

Alternatively, the to-be-executed action sequence of the at least one device may be preset.

Alternatively, the to-be-executed action sequence of the at least one device may be determined by the user.

For example, the first device may display one or more reference action sequences. The user may select the to-be-executed action sequence of the first device from the one or more reference action sequences. The one or more reference sequences may include an unfinished action sequence in an action sequence set of the first device. Alternatively, the one or more reference sequences may include all action sequences in an action sequence set of the first device.

This can provide reference for the user when the user selects a to-be-executed action sequence, thereby improving user experience, avoiding a repeated action sequence, and improving calibration efficiency.

Optionally, the to-be-executed action sequence of the at least one device is determined from an action sequence set.

Some or all of the plurality of devices may share an action sequence set, in other words, action sequence sets of some or all of the plurality of devices may be the same. Alternatively, action sequence sets of the plurality of devices may be different. This is not limited in this embodiment of this application.

Optionally, the to-be-executed action sequence of the at least one device is determined based on at least one of the following: the action that parameter calibration requires to cover, the working condition of the at least one device, or the evaluation results of the parameter combinations of the plurality of devices.

For example, the action that parameter calibration requires to cover may include an action that a national standard requires to cover.

Parameter calibration in the ABS scenario is used as an example. The action that the national standard requires to cover needs to cover low-speed, medium-speed, and high-speed scenarios. To be specific, target vehicle speeds in action sequences need to include three cases: low speed, medium speed, and high speed. If an action sequence in which the target vehicle speed is the low speed has been previously executed, the to-be-executed action sequence may be an action sequence in which the target vehicle speed is the medium speed or an action sequence in which the target vehicle speed is the high speed.

Different working conditions have different requirements for the to-be-executed action sequence.

Parameter calibration in the ABS scenario is used as an example. Road sections with low adhesion coefficients, such as an icy road, require slow acceleration, in other words, a depressing depth of an accelerator pedal should not be excessively large. Roads with high adhesion coefficients, such as an asphalt road, require rapid acceleration, in other words, a large depressing depth of an accelerator pedal is required. For a device on the road section with the low adhesion coefficient, a depressing depth of an accelerator pedal used for an acceleration action in a to-be-executed action sequence is less than or equal to a first pedal threshold, for example, 30%. For a device on the road section with the high adhesion coefficient, a depressing depth of an accelerator pedal used for an acceleration action in a to-be-executed action sequence is greater than or equal to a second pedal threshold, for example, 90%.

If an evaluation result of a parameter combination obtained after a calibration test is performed based on a parameter combination is poor, for example, an evaluation score is less than or equal to an evaluation threshold, after the parameter combination is adjusted, an action sequence executed in a process of performing the calibration test may be used as a to-be-executed action sequence.

A specific execution manner of the to-be-executed action sequence may be set based on a requirement.

For example, the method 400 may be applied to the vehicle calibration scenario. The at least one device, to be specific, at least one vehicle, may execute the to-be-executed action sequence in a self-driving manner, to obtain the test data.

Alternatively, a driver in the at least one vehicle may control the at least one vehicle to perform a to-be-executed action sequence.

For example, the to-be-executed action sequence may be displayed on a vehicle-mounted display of the at least one vehicle, and the driver controls the vehicle to perform the corresponding to-be-executed action sequence.

If the at least one device includes two or more devices, execution manners of all devices in the at least one device may be the same or may be different. For example, some vehicles may use the self-driving manner, and some vehicles may use a driver-driving manner.

After the at least one device completes the calibration test, the test data of the at least one device or an evaluation result of the parameter combination of the at least one device may be obtained. Further, the method 400 may be repeatedly performed based on the test data of the at least one device. In other words, the method 400 in this embodiment of this application may be iteratively performed. For example, step S410 and step S420 are performed, or step S410 to step S430 are repeatedly performed, or step S410 to step S440 are repeatedly performed. Specific execution steps may be set based on a requirement. This is not limited in this embodiment of this application. For example, the evaluation result of the parameter combination of the at least one device may be used as the evaluation results of the parameter combinations of the plurality of devices in step S410, and the method 400 is repeatedly performed. For another example, the evaluation result of the parameter combination of the at least one device may be added to the evaluation results of the parameter combinations of the plurality of devices in step S410, and the method 400 is repeatedly performed. In this case, one device in step S410 may correspond to evaluation results of parameter combinations obtained by the device in a plurality of calibration tests, or an evaluation result of a parameter combination of one device may include evaluation results of parameter combinations obtained by a plurality of calibration tests.

It should be noted that, in a process of repeatedly performing the method 400, devices participating in each iteration, that is, "the at least one device" in the method 400, may be a full set or a subset of to-be-calibrated devices, that is, a full set or a subset of "the plurality of devices" in the method 400. In other words, the devices participating in each iteration may be the same or may be different. This is not limited in this embodiment of this application.

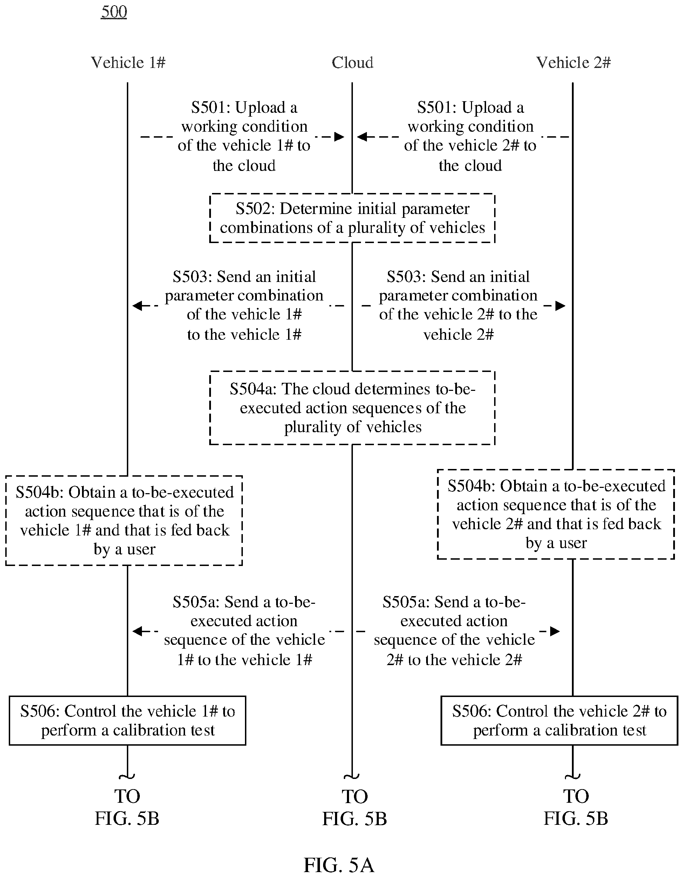

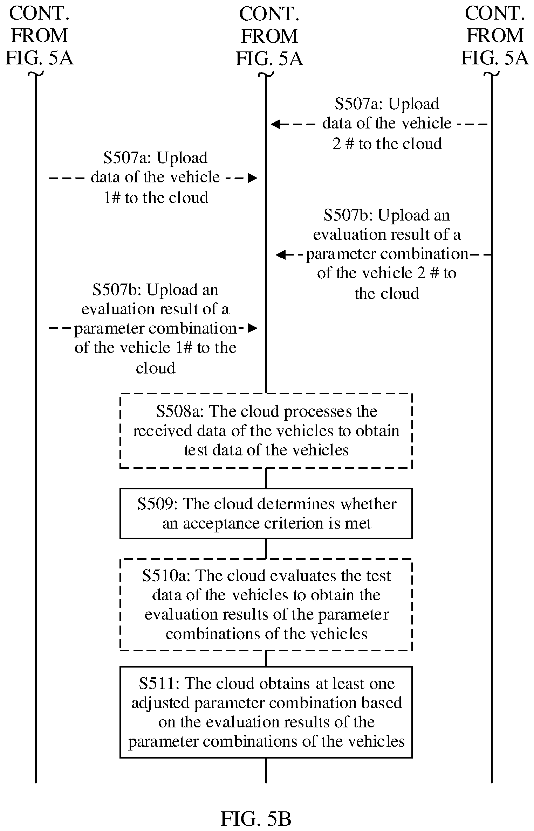

FIG. 5A and FIG. 5B are a schematic flowchart of a parameter calibration method according to an embodiment of this application. A method 500 in FIG. 5A and FIG. 5B is described by using only vehicle calibration as an example, and constitutes no limitation on the solution in this embodiment of this application. The method 500 in FIG. 5A and FIG. 5B may be considered as a specific implementation of the method 400 shown in FIG. 4. For specific description, refer to the method 400. To avoid unnecessary repetition, some repeated descriptions are appropriately omitted when the method 500 is described.

For example, the method 500 may be performed by the calibration system shown in FIG. 3.

The method 500 includes step S501 to step S511. The steps in the method 500 may be performed once or a plurality of times, in other words, iteratively performed.

S501: A plurality of vehicles separately upload working conditions of the plurality of vehicles to a cloud.

The plurality of vehicles are to-be-calibrated vehicles. The to-be-calibrated vehicles may be vehicles of a same model. As shown in FIG. 5A and FIG. 5B, the plurality of vehicles may include a vehicle 1# and a vehicle 2#. The vehicle 1# and the vehicle 2# separately upload respective working conditions to the cloud.

It should be understood that only two vehicles are used as an example in FIG. 5A and FIG. 5B, and a quantity of to-be-calibrated vehicles in this embodiment of this application is not limited.

For example, the working conditions of the plurality of vehicles may be collected by sensors, or may be manually set.

For example, step S501 may be performed by the first communication module and the second communication module in FIG. 3.

In other words, each vehicle uploads a working condition of the vehicle to the first communication module in the cloud by using a respective second communication module. The first communication module in the cloud may store, in the first storage module, the received working condition of each vehicle. Specifically, the working condition of each vehicle may be stored in a working condition module in the first storage module.

For example, the vehicle is in a moving state in a process of performing a calibration test, and data transmission may be performed between the first communication module and the second communication module in a wireless communication manner.

Further, step S501 may further include: The plurality of vehicles upload vehicle configuration information to the cloud.

For example, the vehicle configuration information may be collected by the sensors, or may be manually set.

It should be noted that step S501 is an optional step.

S502: The cloud determines initial parameter combinations of the plurality of vehicles.

The initial parameter combinations of the plurality of vehicles may be understood as an example of the parameter combinations of the plurality of devices in the method 400.

The initial parameter combinations of the plurality of vehicles may be the same or may be different.

For example, the initial parameter combinations of the plurality of vehicles may be respectively determined based on the working conditions of the plurality of vehicles.

Alternatively, the initial parameter combinations of the plurality of vehicles may be randomly selected in a parameter space. The parameter space may also be understood as a value range of each parameter.

Alternatively, the initial parameter combinations of the plurality of vehicles may be set based on historical parameters of a similar vehicle model.

Alternatively, the initial parameter combinations of the plurality of vehicles may be manually determined.

It should be understood that the foregoing manner of determining the initial parameter combination is merely an example. In actual application, a parameter combination may alternatively be initialized in another manner. This is not limited in this embodiment of this application.

For example, step S502 may be performed by the calibration module 212 in FIG. 3.

It should be noted that step S502 is an optional step. For example, an initial parameter combination of at least one vehicle in the plurality of vehicles may alternatively be preset in the at least one vehicle, and does not need to be determined by the cloud.

When the method 500 includes step S502, the method 500 further includes step S503.

S503: The cloud separately sends the initial parameter combinations of the plurality of vehicles to the plurality of vehicles.

As shown in FIG. 5A and FIG. 5B, the cloud sends an initial parameter combination X of the vehicle 1# to the vehicle 1#, and sends an initial parameter combination Y of the vehicle 2# to the vehicle 2#. The initial parameter combination X and the initial parameter combination Y may be the same or may be different.

For example, step S503 may be performed by the first communication module and the second communication module in FIG. 3.

In other words, the cloud sends an initial parameter combination of each vehicle to the second communication module of the vehicle by using the first communication module. The second communication module of each vehicle may store the initial parameter combination in a second storage module of each vehicle. Specifically, the initial parameter combination is stored in a parameter module in the second storage module.

Further, the parameter module may write the initial parameter combination into a control module, for example, into an ECU.

Optionally, the method 500 includes step S504a or step S504b.

S504a: The cloud determines to-be-executed action sequences of the plurality of vehicles.

The to-be-executed action sequences of the plurality of vehicles may be the same or may be different.

For example, the cloud may separately select the to-be-executed action sequences for the plurality of vehicles from an action sequence set.

Alternatively, the to-be-executed action sequences of the plurality of vehicles may be manually determined.

Optionally, the cloud may determine the to-be-executed action sequences of the plurality of vehicles based on at least one of the following: an action coverage degree required by a national standard, the working conditions of the plurality of vehicles, or evaluation results of parameter combinations of the plurality of vehicles.

For specific descriptions, refer to step S440 in the method 400. Details are not described herein again.

For example, step S504 may be performed by the calibration module 212 in FIG. 3.

S504b: The plurality of vehicles obtain to-be-executed action sequences that are of the plurality of vehicles and that are fed back by a user.

As shown in FIG. 5A and FIG. 5B, the vehicle 1# obtains a to-be-executed action sequence M that is of the vehicle 1# and that is fed back by the user. The vehicle 2# obtains a to-be-executed action sequence N that is of the vehicle 2# and that is fed back by the user.

For example, a vehicle may obtain, through a human-computer interface, a to-be-executed action sequence that is of the vehicle and that is fed back by the user.

Further, the vehicle may display one or more reference action sequences by using a vehicle-mounted display. The one or more reference action sequences may be determined based on the action sequence set and a completed action sequence.

It should be understood that step S504a or step S504b is merely an example, and constitutes no limitation on the solution in this embodiment of this application. For example, an action sequence of the at least one vehicle in the plurality of vehicles may alternatively be selected by the at least one vehicle from the action sequence set. For another example, the user may alternatively directly control the vehicle to execute the to-be-executed action sequence. In other words, the user does not need to input the to-be-executed action sequence into the to-be-executed action sequence, but directly controls the vehicle to perform a corresponding action.

When the method 500 includes step S504a, the method 500 further includes step S505a.

S505a: Separately send the to-be-executed action sequences of the plurality of vehicles to the plurality of vehicles.

As shown in FIG. 5A and FIG. 5B, a to-be-executed action sequence M of the vehicle 1# is sent to the vehicle 1#, and a to-be-executed action sequence N of the vehicle 2# is sent to the vehicle 2#.

For example, step S505a may be performed by the first communication module and the second communication module in FIG. 3.

In other words, the cloud sends the to-be-executed action sequence of each vehicle to the second communication module of the vehicle by using the first communication module. The second communication module of each vehicle may store the to-be-executed action sequence in the second storage module of each vehicle. Specifically, the to-be-executed action sequence is stored in an action module in the second storage module.

Further, the action module may send the to-be-executed action sequence to the execution module.

S506: Control the plurality of vehicles to respectively perform calibration tests.

Specifically, the plurality of vehicles are controlled to respectively perform the calibration tests in a same time period.

As shown in FIG. 5A and FIG. 5B, the vehicle 1# is controlled to perform a calibration test, and the vehicle 2# is controlled to perform a calibration test.

The initial parameter combination X of the vehicle 1# is written into an ECU of the vehicle 1#, and the initial parameter combination Y of the vehicle 2# is written into an ECU of vehicle 2#.

Because the initial parameter combinations of the plurality of vehicles have been written into ECUs, step S506 may be understood as that the plurality of vehicles respectively perform the calibration tests based on the parameter combinations in the respective ECUs.

For example, step S506 may be controlling the plurality of vehicles to respectively perform the to-be-executed action sequences of the plurality of vehicles. The vehicle 1# executes the to-be-executed action sequence M, and the vehicle 2# executes the to-be-executed action sequence N.

For example, step S506 may be performed by execution modules of the plurality of vehicles, to be specific, the vehicles are controlled to execute the to-be-executed action sequences in a self-driving manner.

Alternatively, the to-be-executed sequence may be displayed to a driver by using the vehicle-mounted display, and the driver controls the vehicle to execute the to-be-executed action sequence.

It should be noted that different vehicles in the plurality of vehicles may use different driving manners, or may use a same driving manner. This is not limited in this embodiment of this application.

The method 500 includes step S507a or S507b.

S507a: The plurality of vehicles separately upload data of the plurality of vehicles to the cloud.

As shown in FIG. 5A and FIG. 5B, the vehicle 1# uploads data of the vehicle 1# to the cloud, and the vehicle 2# uploads data of the vehicle 2# to the cloud.

For example, data of the vehicle may include data collected by a sensor in a process in which the vehicle performs a calibration test.

Further, the plurality of vehicles separately upload action sequences executed in a process of performing the calibration tests to the cloud, in other words, upload action sequences actually performed by the vehicles in the process of performing the calibration tests to the cloud.

In an implementation, the data collected by the sensor may include valid data and invalid data.

In another implementation, the data collected by the sensor is valid data, and the valid data may be used as test data.

For specific descriptions, refer to the descriptions in step S410 in the method 400. Details are not described herein again.

It should be noted that data uploaded by different vehicles in the plurality of vehicles may be in different forms. For example, data uploaded by some vehicles includes valid data and invalid data, or data uploaded by some vehicles includes only valid data. Alternatively, the data uploaded by the plurality of vehicles may be in a same form. This is not limited in this embodiment of this application.

For example, step S507a may be performed by the first communication module and the second communication module in FIG. 3.

In other words, each vehicle uploads respective data to the first communication module in the cloud by using the respective second communication module.

It should be understood that, because various vehicles may complete executing to-be-executed action sequences at different moments or the like, different vehicles may upload the data at different moments.

S507b: The plurality of vehicles separately upload the evaluation results of the parameter combinations of the plurality of vehicles to the cloud.

As shown in FIG. 5A and FIG. 5B, the vehicle 1# uploads an evaluation result of a parameter combination of the vehicle 1# to the cloud, and the vehicle 2# uploads an evaluation result of a parameter combination of the vehicle 2# to the cloud.

Further, the plurality of vehicles separately upload the action sequences executed in the process of performing the calibration tests to the cloud.

The evaluation results of the parameter combinations of the plurality of vehicles may be fed back by the user. In this case, the plurality of vehicles may obtain the evaluation results that are of the parameter combinations of the plurality of vehicles and that are fed back by the user.

For example, the vehicle may obtain, through the human-computer interface, an evaluation result that is of a parameter combination of the vehicle and that is fed back by the user, and upload the evaluation result of the parameter combination to the cloud.

For example, step S507b may be performed by the first communication module and the second communication module in FIG. 3.

In other words, each vehicle uploads an evaluation result of a respective parameter combination to the first communication module in the cloud by using the respective second communication module.

It should be understood that, because various vehicles complete executing to-be-executed action sequences at different moments or the like, different vehicles may upload evaluation results at different moments.

In another implementation, the method 500 may include step S507a and step S507b.

Specifically, the plurality of vehicles may obtain first parts of the evaluation results of the parameter combinations of the plurality of vehicles and data of the plurality of devices.

The evaluation result of the parameter combination of the vehicle may include a first part and a second part. The first part may be fed back by the user. In this case, the vehicle may obtain the first part that is of the evaluation result of the parameter combination of the vehicle and that is fed back by the user. The second part may be obtained by processing and evaluating, by the cloud, data uploaded by the vehicle.

It should be understood that the foregoing step S507a and step S507b are merely examples. For specific descriptions, refer to the foregoing step S410. Details are not described herein again.

When the method 500 includes step S507a, the method 500 may further include step S508a.

S508a: The cloud processes the received data of the vehicles.

For example, step S508a includes: performing processing such as data filtering, frequency reduction, or noise reduction on the received data of the vehicles, to obtain received test data of the vehicles.

For example, step S508a may be performed by the data processing module in FIG. 3. Further, the data processing module may store the test data in the first storage module. Specifically, the data processing module may store the test data obtained through processing in the calibration data module in the first storage module.

It should be noted that, because different vehicles may upload the data at different moments, the cloud may receive data uploaded by all the vehicles at different moments.

In an implementation, after receiving the data uploaded by all the vehicles, the cloud may perform step S508a on the data of all the vehicles.

In another implementation, the cloud may perform step S508a after receiving the data uploaded by some vehicles. For example, after receiving data uploaded by any vehicle, the cloud performs step S507a on the data of the vehicle.

It should be noted that step S508a is an optional step. For example, the data uploaded by the vehicle may be test data obtained through processing. In this case, the data does not need to be processed by the cloud.

S509: The cloud determines whether an acceptance criterion is met. If the acceptance criterion is met, the procedure ends and calibration is complete. If the acceptance criterion is not met, step S510a is performed when the method 500 includes step S507a, or step S511 is performed when the method 500 does not include step S507a.

For example, step S509 may be performed by the calibration module in FIG. 3.

If the method 500 includes step S507a, step S509 may be performed in the following manner.

In an implementation, the cloud may perform step S509 on the test data of all the vehicles.

For example, the test data of the vehicle may be stored in the first storage module. The calibration module may monitor the first storage module, and perform step S509 after the first storage module receives the test data of all the vehicles in the plurality of vehicles.

In another implementation, the cloud may perform step S509 on test data of some vehicles.

### For example, the test data of the vehicle may be stored in the first storage module.

The calibration module may monitor the first storage module, and perform step S509 based on test data of any vehicle after the first storage module receives the test data of the vehicle.

If the method 500 includes step S5076b, step S509 may be performed in the following manner.

In an implementation, the cloud may perform step S509 on the evaluation results of the parameter combinations of all the vehicles.

For example, the evaluation result of the parameter combination of the vehicle may be stored in the first storage module. The calibration module may monitor the first storage module, and perform step S509 after the first storage module receives the evaluation results of the parameter combinations of all the vehicles in the plurality of vehicles.

In another implementation, the cloud may perform step S508 on evaluation results of parameter combinations of some vehicles.

For example, the evaluation result of the parameter combination of the vehicle may be stored in the first storage module. The calibration module may monitor the first storage module, and perform step S509 based on an evaluation result of a parameter combination of any vehicle after the first storage module receives the evaluation result of the parameter combination of the vehicle.

S510a: The cloud evaluates the test data of the vehicles to obtain the evaluation results of the parameter combinations of the vehicles.

Optionally, the cloud evaluates the test data of the vehicles based on the working conditions of the vehicles, to obtain the evaluation results of the parameter combinations of the vehicles.

For a specific evaluation manner, refer to step S410 in the method 400. Details are not described herein again.

For example, step S510a may be performed by the calibration module in FIG. 3.

S511: The cloud obtains at least one adjusted parameter combination based on the evaluation results of the parameter combinations of the vehicles.

In an implementation, the cloud may perform step S511 after obtaining the evaluation results of the parameter combinations of some vehicles in the vehicles participating in this iteration. When step S511 is performed for the first time, that is, in a first iteration process, vehicles participating in the iteration are all to-be-calibrated vehicles. For example, the cloud may perform step S511 in real time after obtaining the evaluation result of the parameter combination of any vehicle.

For example, step S511 may be implemented by using a Bayesian optimization algorithm.

For example, the cloud may obtain an average value and a variance of evaluation results of value points in the parameter distribution space through fitting according to a Bayesian principle and based on currently obtained evaluation results of the parameter combinations of the vehicles, then determine at least one value point with a highest score according to a UCB formula, and use the at least one value point as the at least one adjusted parameter combination.

Alternatively, the cloud may optimize an average value and a variance of existing evaluation results of value points in the parameter distribution space according to a Bayesian principle and based on currently obtained evaluation results of the parameter combinations of the vehicles, then determine, according to a UCB formula, a parameter combination corresponding to a maximum value, and use the parameter combination as the adjusted parameter combination.

An existing evaluation result of each value point in the parameter distribution space may be obtained through fitting based on a previously obtained evaluation result of a parameter combination of the vehicle.

Alternatively, step S511 may be implemented by using a genetic algorithm.

For example, when evaluation results of parameter combinations of at least two vehicles are stored in the cloud, an operation such as crossover or mutation is performed on one or more parameter combinations that are good in the evaluation results of the parameter combinations of the at least two vehicles, and an obtained parameter combination is used as the at least one adjusted parameter combination.

In another implementation, the cloud may perform step S511 after obtaining evaluation results of parameter combinations of all the vehicles in the vehicles participating in this iteration.

For example, step S511 may be implemented by using a Bayesian optimization algorithm.

For example, the cloud may obtain an average value and a variance of evaluation results of value points in the parameter distribution space through fitting according to a Bayesian principle and based on the evaluation results of the parameter combinations of the vehicles participating in this iteration, then determine at least one value point with a highest score according to a UCB formula, and use the at least one value point as the at least one adjusted parameter combination.

Alternatively, the cloud may optimize an average value and a variance of existing evaluation results of value points in the parameter distribution space according to a Bayesian principle and based on the evaluation results of the parameter combinations of the vehicles participating in this iteration, then determine, according to a UCB formula, a parameter combination corresponding to a maximum value, and use the parameter combination as the adjusted parameter combination.

An existing evaluation result of each value point in the parameter distribution space may be obtained through fitting based on a previously obtained evaluation result of a parameter combination of the vehicle.

In other words, in a process of repeatedly performing step S511, the cloud may adjust the parameter combination of the vehicle based on the evaluation result of the parameter combination obtained in a current iteration process and the evaluation result of the parameter combination obtained in a previous iteration process. In other words, the cloud may adjust the parameter combinations of the vehicles based on currently obtained evaluation results of all of parameter combinations.

Alternatively, step S511 may be implemented by using a genetic algorithm.

For example, when evaluation results of parameter combinations of at least two vehicles are stored in the cloud, an operation such as crossover or mutation is performed on one or more parameter combinations that are good in the evaluation results of the parameter combinations of the at least two vehicles, and an obtained parameter combination is used as the at least one adjusted parameter combination.

The evaluation results of the parameter combinations of the at least two vehicles may be obtained in one iteration process, or may be obtained in a plurality of iteration processes.

In other words, in a process of repeatedly performing step S511, the cloud may adjust the parameter combination of the vehicle based on the evaluation result of the parameter combination obtained in a current iteration process and the evaluation result of the parameter combination obtained in a previous iteration process. In other words, the cloud may adjust the parameter combinations of the vehicles based on currently obtained evaluation results of all of parameter combinations.

Further, when the parameter combinations of the vehicles participating in this iteration are the same, and working conditions of the vehicles participating in this iteration are different, step S511 may further include the following steps:

(1) Process the evaluation results of the parameter combinations of the vehicles participating in this iteration, to obtain a summary evaluation result.

For example, a weighted average value of the evaluation results of the parameter combinations of the devices participating in this iteration is used as the summary evaluation result. For another example, a minimum value in the evaluation results of the parameter combinations of the devices participating in this iteration is used as the summary evaluation result. For still another example, a maximum value in the evaluation results of the parameter combinations of the devices participating in this iteration is used as the summary evaluation result. A manner of determining the summary evaluation result is not limited in this embodiment of this application.

(2) Obtain the at least one adjusted parameter combination based on the summary evaluation result.

Step (2) may be understood as optimizing the current parameter combinations based on the summary evaluation result. For a specific optimization manner, refer to the foregoing descriptions. For example, when the Bayesian optimization algorithm is used, "the evaluation results of the parameter combinations of the devices" in the foregoing optimization method is replaced with "the summary evaluation result".

The at least one adjusted parameter combination is sent to the at least one vehicle, that is, a vehicle participating in next iteration. The initial parameter combination in step S504 to step S511 is replaced with the adjusted parameter combination, the plurality of vehicles in step S504 to step S511 is replaced with the at least one vehicle, and step S504 to step S511 are repeated until calibration is completed. In other words, when steps S504 to S511 are executed for the first time, the vehicles participating in iteration are the plurality of vehicles and all of the to-be-calibrated vehicles. The parameter combinations of the plurality of vehicles are the initial parameter combinations of the plurality of vehicles. When step S506 to step S511 are subsequently performed, vehicles participating in each iteration may be some or all of the plurality of vehicles, and the parameter combination is the adjusted parameter combination obtained in step S511.

For example, the at least one vehicle is determined based on at least one of the following: the working conditions of the plurality of devices or the at least one adjusted parameter combination.

The at least one vehicle may be determined by the calibration module 212 in FIG. 3.

Alternatively, the at least one vehicle may be a vehicle in the evaluation results of the currently obtained parameter combinations of the vehicles. For example, after obtaining the evaluation result of the parameter combination of the vehicle 1#, the cloud performs step S511 in real time. In this case, the vehicle 1# may be used as one of vehicles participating in next iteration.

For a method for determining the at least one vehicle, refer to step S430 in the foregoing method 400. Details are not described herein again.

The vehicles participating in each iteration may be the same or may be different.

It should be noted that the method in this embodiment of this application is described by using only a vehicle as an example in the method 500, and constitutes no limitation on the solution in this embodiment of this application.

In an implementation, some or all of the plurality of vehicles in the method 500 may alternatively be replaced with test benches.

The test benches may be simulated and set to different working conditions, and the test benches may be used to replace some or all vehicles. The test bench may be used in scenarios such as engine calibration or motor calibration to further reduce calibration costs, improve data collection efficiency, and further improve calibration efficiency.

Because the test benches may be simulated and set to different working conditions, when the working conditions of the test benches change, updated working conditions of the test benches may be uploaded to the cloud. Working conditions of a same vehicle usually do not change in a calibration process, and the plurality of vehicles may upload the working conditions once in step S501. The working condition of the test bench may be set based on a requirement. After some or all of the plurality of vehicles are replaced with the test benches, when the working conditions of the test benches change, the updated working conditions of the test benches may be uploaded to the cloud in real time.

When a calibration test is performed by using the test bench, data transmission may be performed between the first communication module and the second communication module in the wireless communication manner, or data transmission may be performed in a wired communication manner.

A parameter calibration apparatus may be deployed in a cloud environment. The cloud environment is an entity that provides users with cloud services by using basic resources in a cloud computing mode. The cloud environment includes a cloud data center and a cloud service platform. The cloud data center includes a large quantity of basic resources (including computing resources, storage resources, and network resources) owned by a cloud service provider. The computing resources included in the cloud data center may be a large quantity of computing devices (for example, servers).

The parameter calibration apparatus may be a server that is in the cloud data center and that is configured to calibrate a parameter. Alternatively, the parameter calibration apparatus may be a software apparatus deployed on a server or a virtual machine in the cloud data center, and the software apparatus is configured to calibrate a parameter. The software apparatus may be deployed on a plurality of servers in a distributed manner, or deployed on a plurality of virtual machines in a distributed manner, or deployed on a virtual machine and a server in a distributed manner.

The parameter calibration apparatus is abstracted by the cloud service provider into a parameter calibration cloud service on the cloud service platform and provided to a user. After the user purchases the cloud service, the cloud environment provides a parameter calibration service to the user by using the parameter calibration apparatus. The data of the device, the evaluation result of the parameter combination of the device, or the like may be uploaded to the cloud environment through a communication interface. The parameter calibration apparatus optimizes a parameter combination of a device, and an optimization result may be returned to the device in which the user is located.

When the parameter calibration apparatus is the software apparatus, different modules of the parameter calibration apparatus may be deployed in different environments or devices. For example, some modules of the parameter calibration apparatus are deployed in a terminal device (for example, a vehicle, a smartphone, a laptop computer, a tablet computer, a personal desktop computer, or a smart camera), and the other modules of the parameter calibration apparatus are deployed in the cloud data center (deployed on the server or the virtual machine in the cloud data center).

Functions of the parameter calibration method are implemented in cooperation between parts of the parameter calibration apparatus deployed in different environments or devices. For example, for a deployment status of the parameter calibration apparatus, refer to FIG. 3.

It may be understood that this application does not limit which part of the parameter calibration apparatus is deployed on a terminal computing device and which part is deployed in the cloud data center. In actual application, adaptive deployment may be performed based on a computing capability or a specific application requirement of the terminal computing device.

When the parameter calibration apparatus is the software apparatus, the parameter calibration apparatus may alternatively be independently deployed on a computing device in any environment. (for example, independently deployed on a terminal device or a computing device in the cloud data center).

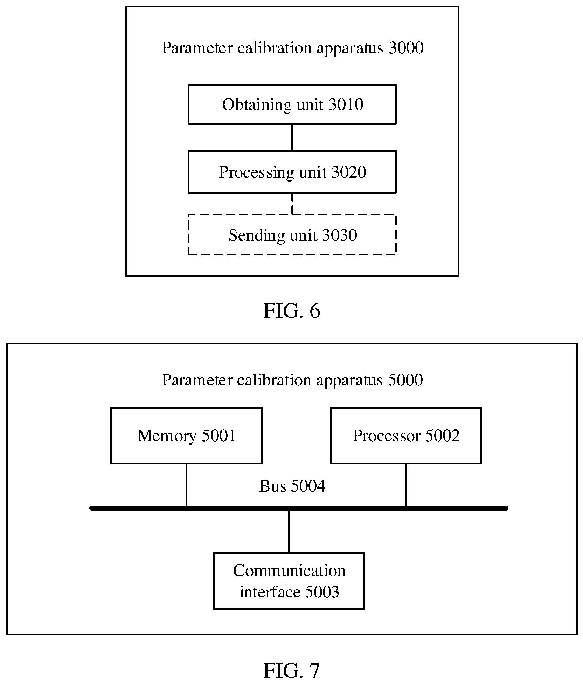

The following describes apparatuses in embodiments of this application with reference to FIG. 6 and FIG. 7. It should be understood that the following described apparatuses can perform the methods in the foregoing embodiments of this application. To avoid unnecessary repetition, repeated descriptions are appropriately omitted below when the apparatuses in embodiments of this application are described.

FIG. 6 is a schematic block diagram of a parameter calibration apparatus according to an embodiment of this application. A parameter calibration apparatus 3000 shown in FIG. 6 includes an obtaining unit 3010 and a processing unit 3020.

The obtaining unit 3010 and the processing unit 3020 may be configured to perform the parameter calibration method in embodiments of this application, and may be specifically configured to perform the method 400 or the method 500.

In an implementation, the obtaining unit 3010 is configured to obtain evaluation results of parameter combinations of a plurality of devices, where the evaluation results of the parameter combinations of the plurality of devices are obtained by respectively performing calibration tests by the plurality of devices in a first time period based on the parameter combinations of the plurality of devices, and the first time period is less than or equal to a first threshold. The processing unit 3020 is configured to obtain at least one adjusted parameter combination based on the evaluation results of the parameter combinations of the plurality of devices.

Optionally, in an embodiment, the parameter combinations of the plurality of devices are the same, and working conditions of the plurality of devices are different; and the processing unit 3020 is specifically configured to: process the evaluation results of the parameter combinations of the plurality of devices to obtain a summary evaluation result; and obtain the at least one adjusted parameter combination based on the summary evaluation result.

Optionally, in an embodiment, the apparatus further includes: a sending unit 3030, configured to send the at least one adjusted parameter combination to at least one device.

Optionally, in an embodiment, the at least one device is determined based on at least one of the following: the working conditions of the plurality of devices or the at least one adjusted parameter combination.

Optionally, in an embodiment, the evaluation results of the parameter combinations of the plurality of devices are obtained by evaluating test data of the plurality of devices, and the test data of the plurality of devices is determined based on data collected in a process in which the plurality of devices respectively perform the calibration tests in the first time period based on the parameter combinations of the plurality of devices.

Optionally, in an embodiment, the evaluation results of the parameter combinations of the plurality of devices are fed back by a user.

Optionally, in an embodiment, the sending unit 3030 is further configured to: separately send a to-be-executed action sequence of the at least one device to the at least one device, where the to-be-executed action sequence of the at least one device includes an action that needs to be performed by the at least one device in a process of performing a calibration test based on the adjusted parameter combination of the at least one device.

Optionally, in an embodiment, the to-be-executed action sequence of the at least one device is determined based on at least one of the following: an action that parameter calibration requires to cover, a working condition of the at least one device, or the evaluation results of the parameter combinations of the plurality of devices.

Optionally, in an embodiment, the plurality of devices include at least one of the following: a vehicle or a test bench.

In another implementation, the obtaining unit 30103 is configured to obtain an adjusted parameter combination, where the adjusted parameter combination is obtained based on evaluation results of parameter combinations of a plurality of devices, the plurality of devices include a first device, the evaluation results of the parameter combinations of the plurality of devices are obtained by respectively performing calibration tests by the plurality of devices in a first time period based on the parameter combinations of the plurality of devices, and the first time period is less than or equal to a first threshold.

The processing unit 3020 is configured to control the first device to perform a calibration test based on the adjusted parameter combination.

Optionally, in an embodiment, the parameter combinations of the plurality of devices are the same, working conditions of the plurality of devices are different, the adjusted parameter combination is obtained based on a summary evaluation result, and the summary evaluation result is obtained by processing the evaluation results of the parameter combinations of the plurality of devices.

Optionally, in an embodiment, the first device is determined based on at least one of the following: the working conditions of the plurality of devices or the adjusted parameter combination.

Optionally, in an embodiment, the evaluation results of the parameter combinations of the plurality of devices are obtained by evaluating test data of the plurality of devices, and the test data of the plurality of devices is determined based on data collected in a process in which the plurality of devices respectively perform the calibration tests in the first time period based on the parameter combinations of the plurality of devices.

Optionally, in an embodiment, the evaluation results of the parameter combinations of the plurality of devices are fed back by a user.

Optionally, in an embodiment, the obtaining unit 3010 is further configured to: obtain a to-be-executed action sequence of the first device, where the to-be-executed action sequence of the first device includes an action that needs to be performed by the first device in a process of performing the calibration test based on the adjusted parameter combination.

Optionally, in an embodiment, the to-be-executed action sequence of the first device is determined based on at least one of the following: an action that parameter calibration requires to cover, a working condition of the first device, or the evaluation results of the parameter combinations of the plurality of devices.

Optionally, in an embodiment, the first device is a vehicle or a test bench.

It should be noted that the apparatus 3000 is embodied in a form of a functional unit. The term "unit" herein may be implemented in a form of software and/or hardware. This is not specifically limited.

For example, the "unit" may be a software program, a hardware circuit, or a combination thereof that implements the foregoing function. The hardware circuit may include an application-specific integrated circuit (application-specific integrated circuit, ASIC), an electronic circuit, a processor (for example, a shared processor, a dedicated processor, or a group processor) configured to execute one or more software or firmware programs, a memory, a merged logical circuit, and/or another appropriate component that supports the described function.

Therefore, in the examples described in embodiments of this application, the units can be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

FIG. 7 is a schematic diagram of a hardware structure of a parameter calibration apparatus according to an embodiment of this application. A parameter calibration apparatus 5000 (the apparatus 5000 may be specifically a computer device) shown in FIG. 7 includes a memory 5001, a processor 5002, a communication interface 5003, and a bus 5004. The memory 5001, the processor 5002, and the communication interface 5003 communicate with each other through the bus 5004.

The memory 5001 may be a read-only memory (read-only memory, ROM), a static storage device, a dynamic storage device, or a random access memory (random access memory, RAM). The memory 5001 may store a program. When the program stored in the memory 5001 is executed by the processor 5002, the processor 5002 is configured to perform the steps of the parameter calibration method in embodiments of this application. Specifically, the processor 5002 may perform the method 400 shown in FIG. 4, or perform the method 500 shown in FIG. 5A and FIG. 5B.

The processor 5002 may be a general-purpose central processing unit (central processing unit, CPU), a microprocessor, an application-specific integrated circuit (application-specific integrated circuit, ASIC), a graphics processing unit (graphics processing unit, GPU), or one or more integrated circuits, and is configured to execute a related program, to implement the parameter calibration method in the method embodiment of this application.

The processor 5002 may alternatively be an integrated circuit chip, and has a signal processing capability. In an implementation process, the steps of the parameter calibration method in this application may be implemented by using a hardware integrated logical circuit in the processor 5002, or by using instructions in a form of software.

The processor 5002 may alternatively be a general-purpose processor, a digital signal processor (digital signal processing, DSP), an application-specific integrated circuit (ASIC), a field programmable gate array (field programmable gate array, FPGA) or another programmable logic device, a discrete gate or transistor logic device, or a discrete hardware component. The methods, the steps, and the logical block diagrams that are disclosed in embodiments of this application may be implemented or performed. The general-purpose processor may be a microprocessor, or the processor may be any conventional processor or the like. Steps of the methods disclosed with reference to embodiments of this application may be directly executed and accomplished by using a hardware decoding processor, or may be executed and accomplished by using a combination of hardware and a software module in the decoding processor. The software module may be located in a mature storage medium in the art, for example, a random access memory, a flash memory, a read-only memory, a programmable read-only memory, an electrically erasable programmable memory, or a register. The storage medium is located in the memory 5001. The processor 5002 reads information in the memory 5001, and completes, with reference to hardware of the processor 5002, functions that need to be executed by the units included in the apparatus shown in FIG. 6, or performs the parameter calibration method shown in FIG. 4 or FIG. 5A and FIG. 5B in the method embodiment of this application.

The communication interface 5003 uses a transceiver apparatus, for example, including but not limited to a transceiver, to implement communication between the apparatus 5000 and another device or a communication network. For example, an evaluation result of a parameter combination may be obtained through the communication interface 5003.

The bus 5004 may include a path for transferring information between various components (for example, the memory 5001, the processor 5002, and the communication interface 5003) of the apparatus 5000.

It should be noted that although only the memory, the processor, and the communication interface are shown in the apparatus 5000, in a specific implementation process, a person skilled in the art should understand that the apparatus 5000 may further include another component necessary for implementing normal running. In addition, based on a specific requirement, a person skilled in the art should understand that the apparatus 5000 may further include a hardware component for implementing another additional function. In addition, a person skilled in the art should understand that the apparatus 5000 may alternatively include only a component required for implementing embodiments of this application, and does not need to include all the components shown in FIG. 7.

It should be understood that, the processor in embodiments of this application may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or a transistor logic device, a discrete hardware component, or the like. The general-purpose processor may be a microprocessor, or the processor may be any conventional processor or the like.

It may further be understood that the memory in embodiments of this application may be a volatile memory or a nonvolatile memory, or may include a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. By way of example, and not limitation, random access memories (random access memories, RAMs) in many forms may be used, for example, a static random access memory (static RAM, SRAM), a dynamic random access memory (DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

All or some of the foregoing embodiments may be implemented by using software, hardware, firmware, or any combination thereof. When software is used to implement embodiments, the foregoing embodiments may be implemented completely or partially in a form of a computer program product. The computer program product includes one or more computer instructions or computer programs. When the program instructions or the computer programs are loaded and executed on a computer, the procedures or functions according to embodiments of this application are all or partially generated. The computer may be a general-purpose computer, a special-purpose computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), or a semiconductor medium. The semiconductor medium may be a solid-state drive.

This application further provides a computer program product. The computer program product includes computer program code. When the computer program code is run on a computer, the computer is enabled to perform the method in any one of the foregoing method embodiments.

This application further provides a computer-readable medium. The computer-readable medium stores program code. When the program code is run on a computer, the computer is enabled to perform the method in any one of the foregoing method embodiments.

This application further provides an electronic device. The electronic device includes the parameter calibration apparatus in any one of the foregoing apparatus embodiments.

Unless otherwise defined, all technical and scientific terms used in this specification have same meanings as those usually understood by a person skilled in the art of this application. Terms used in this specification of this application are merely intended to describe specific embodiments, but are not intended to limit this application.

A person of ordinary skill in the art may be aware that, in combination with the examples described in embodiments disclosed in this specification, units and algorithm steps can be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments provided in this application, it should be understood that the disclosed system, apparatus, and method may be implemented in other manners. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit.

When the functions are implemented in a form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, or a network device) to perform all or some of the steps of the methods described in embodiments of this application. The foregoing storage medium includes any medium that can store program code, for example, a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A parameter calibration method, comprising:
obtaining evaluation results of parameter combinations of a plurality of devices, wherein the evaluation results of the parameter combinations of the plurality of devices are obtained by respectively performing calibration tests by the plurality of devices in a first time period based on the parameter combinations of the plurality of devices, and the first time period is less than or equal to a first threshold; and
obtaining at least one adjusted parameter combination based on the evaluation results of the parameter combinations of the plurality of devices.

2. The method according to claim 1, wherein the parameter combinations of the plurality of devices are the same, and working conditions of the plurality of devices are different; and
the obtaining at least one adjusted parameter combination based on the evaluation results of the parameter combinations of the plurality of devices comprises:
processing the evaluation results of the parameter combinations of the plurality of devices to obtain a summary evaluation result; and
obtaining the at least one adjusted parameter combination based on the summary evaluation result.

3. The method according to claim 1 or 2, wherein the method further comprises:
sending the at least one adjusted parameter combination to at least one device.

4. The method according to claim 3, wherein the at least one device is determined based on at least one of the following:
the working conditions of the plurality of devices or the at least one adjusted parameter combination.

5. The method according to any one of claims 1 to 4, wherein the evaluation results of the parameter combinations of the plurality of devices are obtained by evaluating test data of the plurality of devices, and the test data of the plurality of devices is determined based on data collected in a process in which the plurality of devices respectively perform the calibration tests in the first time period based on the parameter combinations of the plurality of devices.

6. The method according to any one of claims 1 to 4, wherein the evaluation results of the parameter combinations of the plurality of devices are fed back by a user.

7. The method according to any one of claims 3 to 6, wherein the method further comprises:
separately sending a to-be-executed action sequence of the at least one device to the at least one device, wherein the to-be-executed action sequence of the at least one device comprises an action that needs to be performed by the at least one device in a process of performing a calibration test based on the adjusted parameter combination of the at least one device.

8. The method according to claim 7, wherein the to-be-executed action sequence of the at least one device is determined based on at least one of the following:
an action that parameter calibration requires to cover, a working condition of the at least one device, or the evaluation results of the parameter combinations of the plurality of devices.

9. The method according to any one of claims 1 to 8, wherein the plurality of devices comprise at least one of the following: a vehicle or a test bench.

10. A parameter calibration method, comprising:
obtaining an adjusted parameter combination, wherein the adjusted parameter combination is obtained based on evaluation results of parameter combinations of a plurality of devices, the plurality of devices comprise a first device, the evaluation results of the parameter combinations of the plurality of devices are obtained by respectively performing calibration tests by the plurality of devices in a first time period based on the parameter combinations of the plurality of devices, and the first time period is less than or equal to a first threshold; and
controlling the first device to perform a calibration test based on the adjusted parameter combination.

11. The method according to claim 10, wherein the parameter combinations of the plurality of devices are the same, working conditions of the plurality of devices are different, the adjusted parameter combination is obtained based on a summary evaluation result, and the summary evaluation result is obtained by processing the evaluation results of the parameter combinations of the plurality of devices.

12. The method according to claim 10 or 11, wherein the first device is determined based on at least one of the following:
the working conditions of the plurality of devices or the adjusted parameter combination.

13. The method according to any one of claims 10 to 12, wherein the evaluation results of the parameter combinations of the plurality of devices are obtained by evaluating test data of the plurality of devices, and the test data of the plurality of devices is determined based on data collected in a process in which the plurality of devices respectively perform the calibration tests in the first time period based on the parameter combinations of the plurality of devices.

14. The method according to any one of claims 10 to 12, wherein the evaluation results of the parameter combinations of the plurality of devices are fed back by a user.

15. The method according to any one of claims 10 to 14, wherein the method further comprises:
obtaining a to-be-executed action sequence of the first device, wherein the to-be-executed action sequence of the first device comprises an action that needs to be performed by the first device in a process of performing the calibration test based on the adjusted parameter combination.

16. The method according to claim 15, wherein the to-be-executed action sequence of the first device is determined based on at least one of the following:
an action that parameter calibration requires to cover, a working condition of the first device, or the evaluation results of the parameter combinations of the plurality of devices.

17. The method according to any one of claims 10 to 16, wherein the first device is a vehicle or a test bench.

18. A parameter calibration apparatus, comprising:
an obtaining unit, configured to obtain evaluation results of parameter combinations of a plurality of devices, wherein the evaluation results of the parameter combinations of the plurality of devices are obtained by respectively performing calibration tests by the plurality of devices in a first time period based on the parameter combinations of the plurality of devices, and the first time period is less than or equal to a first threshold; and
a processing unit, configured to obtain at least one adjusted parameter combination based on the evaluation results of the parameter combinations of the plurality of devices.

19. The apparatus according to claim 18, wherein the parameter combinations of the plurality of devices are the same, and working conditions of the plurality of devices are different; and
the processing unit is specifically configured to:
process the evaluation results of the parameter combinations of the plurality of devices to obtain a summary evaluation result; and
obtain the at least one adjusted parameter combination based on the summary evaluation result.

20. The apparatus according to claim 18 or 19, wherein the apparatus further comprises:
a sending unit, configured to send the at least one adjusted parameter combination to at least one device.

21. The apparatus according to claim 20, wherein the at least one device is determined based on at least one of the following:
the working conditions of the plurality of devices or the at least one adjusted parameter combination.

22. The apparatus according to any one of claims 18 to 21, wherein the evaluation results of the parameter combinations of the plurality of devices are obtained by evaluating test data of the plurality of devices, and the test data of the plurality of devices is determined based on data collected in a process in which the plurality of devices respectively perform the calibration tests in the first time period based on the parameter combinations of the plurality of devices.

23. The apparatus according to any one of claims 18 to 21, wherein the evaluation results of the parameter combinations of the plurality of devices are fed back by a user.

24. The apparatus according to any one of claims 20 to 23, wherein the sending unit is further configured to:
separately send a to-be-executed action sequence of the at least one device to the at least one device, wherein the to-be-executed action sequence of the at least one device comprises an action that needs to be performed by the at least one device in a process of performing a calibration test based on the adjusted parameter combination of the at least one device.

25. The apparatus according to claim 24, wherein the to-be-executed action sequence of the at least one device is determined based on at least one of the following:
an action that parameter calibration requires to cover, a working condition of the at least one device, or the evaluation results of the parameter combinations of the plurality of devices.

26. The apparatus according to any one of claims 18 to 25, wherein the plurality of devices comprise at least one of the following: a vehicle or a test bench.

27. A parameter calibration apparatus, comprising:
an obtaining unit, configured to obtain an adjusted parameter combination, wherein the adjusted parameter combination is obtained based on evaluation results of parameter combinations of a plurality of devices, the plurality of devices comprise a first device, the evaluation results of the parameter combinations of the plurality of devices are obtained by respectively performing calibration tests by the plurality of devices in a first time period based on the parameter combinations of the plurality of devices, and the first time period is less than or equal to a first threshold; and
a processing unit, configured to control the first device to perform a calibration test based on the adjusted parameter combination.

28. The apparatus according to claim 27, wherein the parameter combinations of the plurality of devices are the same, working conditions of the plurality of devices are different, the adjusted parameter combination is obtained based on a summary evaluation result, and the summary evaluation result is obtained by processing the evaluation results of the parameter combinations of the plurality of devices.

29. The apparatus according to claim 27 or 28, wherein the first device is determined based on at least one of the following:
the working conditions of the plurality of devices or the adjusted parameter combination.

30. The apparatus according to any one of claims 27 to 29, wherein the evaluation results of the parameter combinations of the plurality of devices are obtained by evaluating test data of the plurality of devices, and the test data of the plurality of devices is determined based on data collected in a process in which the plurality of devices respectively perform the calibration tests in the first time period based on the parameter combinations of the plurality of devices.

31. The apparatus according to any one of claims 27 to 29, wherein the evaluation results of the parameter combinations of the plurality of devices are fed back by a user.

32. The apparatus according to any one of claims 27 to 31, wherein the obtaining unit is further configured to:
obtain a to-be-executed action sequence of the first device, wherein the to-be-executed action sequence of the first device comprises an action that needs to be performed by the first device in a process of performing the calibration test based on the adjusted parameter combination.

33. The apparatus according to claim 32, wherein the to-be-executed action sequence of the first device is determined based on at least one of the following:
an action that parameter calibration requires to cover, a working condition of the first device, or the evaluation results of the parameter combinations of the plurality of devices.

34. The apparatus according to any one of claims 27 to 33, wherein the first device is a vehicle or a test bench.

35. A computer-readable storage medium, wherein the computer-readable storage medium stores instructions executed by a computing device, and the instructions are used to implement the parameter calibration method according to any one of claims 1 to 9 or claims 10 to 17.

36. A computer program product comprising instructions, wherein when the computer program product runs on a computer, the computer is enabled to perform the parameter calibration method according to any one of claims 1 to 9 or claims 10 to 17.
